# EUROPEAN PATENT APPLICATION

(11) **EP 4 813 919 A1**
(43) Date of publication of application: **30.09.2026**
(21) Application number: 24894209.6
(22) Date of filing: 21.11.2024
(51) Int. Cl.: C01B 39/48, C08K 3/34, C08L 63/00, C08L 101/00, H01L 23/29, H01L 23/31

(54) **ZEOLITE, RESIN COMPOSITION, LIQUID SEALING AGENT, UNDERFILL MATERIAL, METHOD FOR PRODUCING SEALING MATERIAL, AND ELECTRONIC DEVICE**

(30) Priority: 22.11.2023 JP 2023198534; 31.01.2024 JP 2024012465
(71) Applicant: Mitsubishi Chemical Corporation, Tokyo 100-8251 (JP)
(72) Inventor: TANAKA, Yutaro, Tokyo 100-8251 (JP); OHNISHI, Ryohji, Tokyo 100-8251 (JP); HIKIMA, Shu, Tokyo 100-8251 (JP); KATAGIRI, Noriko, Tokyo 100-8251 (JP); YAMADA, Hiroto, Tokyo 100-8251 (JP); NAKANO, Chie, Tokyo 100-8251 (JP); TAKEWAKI, Takahiko, Tokyo 100-8251 (JP)
(74) Representative: Hoffmann Eitle
(86) International application number: PCT/JP2024/041342
(87) International publication number: WO 2025/110218

(57) **Abstract**

A zeolite in which a weight loss percentage at 800°C based on a weight at 400°C is 1% or more as measured by thermogravimetric analysis (TGA), when the zeolite is heated to 800°C at a temperature raising rate of 10°C/min and held at 800°C for 10 minutes in an air atmosphere; a circularity of primary particles is 0.800 or more; and 40% or less of particles have a particle size of 3 µm or more as measured by volume-based particle size distribution. The present invention can provide a zeolite for obtaining a resin composition having low hygroscopicity, a low coefficient of thermal expansion after curing, low viscosity, and high gap infiltration.

## Description

### Technical Field

The present invention relates to a zeolite, a resin composition, a liquid sealing agent, an underfill material, a method for producing a sealing material, and an electronic device.

### Background Art

A liquid sealing agent used as an underfill material is required to have excellent injectability, adhesiveness, curability, storage stability, and the like, and not to generate voids. The portion sealed with the liquid sealing agent is required to have excellent moisture resistance, thermal cycle resistance, reflow resistance, crack resistance, warp resistance, and the like. To satisfy the requirements described above, a liquid sealing agent containing an epoxy resin as a main agent is widely used as an underfill material.

To improve moisture resistance and thermal cycle resistance, in particular, thermal cycle resistance, of the portion sealed with the liquid sealing agent, it is known to control the difference in the coefficient of thermal expansion between a substrate made of an organic material, such as an epoxy resin, and a semiconductor element and reinforce a bump electrode by using a filler made of an inorganic substance (which hereinafter may be referred to as "inorganic filler") such as a silica filler as a liquid sealing agent (see Patent Literature 1).

### Citation List

### Patent Literature

Patent Literature 1: JP 2007-56070 A

### Summary of Invention

### Technical Problem

A liquid sealing agent (resin composition) using an inorganic filler such as a silica filler does not have a sufficiently low coefficient of thermal expansion, and is required to have a further low coefficient of thermal expansion from the viewpoint of thermal cycle resistance and the like. As an inorganic filler having a low coefficient of thermal expansion, zeolite is known. However, a liquid sealing agent in which zeolite is blended tends to have high viscosity, and injectability (gap infiltration) when used as an underfill material deteriorates. Thus, it is difficult to obtain a liquid sealing agent having good injectability while lowering the coefficient of thermal expansion of a cured product.

Zeolite is known to have high hygroscopicity, but because the dielectric constant, reliability, and the like of electronic materials may decrease due to the presence of water, zeolite used for the application is required to have low hygroscopicity.

An object of the present invention is to provide a zeolite for producing a resin composition having low hygroscopicity, a low coefficient of thermal expansion after curing, low viscosity, and good gap infiltration.

### Solution to Problem

As a result of intensive studies on the object, the inventors of the present invention have found that the object can be achieved by using a zeolite having a specific configuration, and have completed the present invention.

The gist of the present invention is as follows.
[1] A zeolite in which a weight loss percentage at 800°C based on a weight at 400°C is 1% or more as measured by thermogravimetric analysis (TGA), when the zeolite is heated to 800°C at a temperature raising rate of 10°C/min and held at 800°C for 10 minutes in an air atmosphere; a circularity of primary particles is 0.800 or more; and 40% or less of particles have a particle size of 3 µm or more as measured by volume-based particle size distribution.
[2] The zeolite according to [1], having d6r as CBU.
[3] The zeolite according to [1] or [2], having a structure of a ring having eight or fewer oxygen atoms.
[4] The zeolite according to any one of [1] to [3], having a CHA-type structure.
[5] A resin composition including the zeolite described in any one of [1] to [4] and a resin.
[6] The resin composition according to [5], wherein the resin includes at least one selected from the group consisting of an epoxy resin and a polyimide resin.
[7] The resin composition according to [5] or [6], wherein the resin includes an epoxy resin.
[8] A liquid sealing agent including the resin composition described in any one of [5] to [7].
[9] An underfill material including the resin composition described in any one of [5] to [7].
[10] A method for producing a sealing material, the method including filling a gap with the resin composition described in any one of [5] to [7] and then curing the resin composition.
[11] An electronic device including the sealing material produced by the production method described in [10].

### Advantageous Effects of Invention

The present invention can provide a zeolite for producing a resin composition having low hygroscopicity, a low coefficient of thermal expansion after curing, low viscosity, and high gap infiltration.

### Description of Embodiments

### First Aspect

### [Zeolite]

Zeolite usually refers to a group of crystalline substances having a framework composed of a three-dimensional network formed by containing silicon or aluminum and oxygen and pores derived from the framework structure. Such a characteristic structure is applied to adsorbents and catalysts. Thus, organic substances, such as an organic structure directing agent, taken into the pores in the middle of synthesis of zeolite are generally removed through calcination or the like because they block the pores and cause a decrease in adsorption capacity and catalytic capacity of the zeolite. However, the zeolite according to a first aspect of the present invention (which hereinafter may be referred to as "present zeolite I") is characterized by containing, inside the pores, an organic substance, preferably a component derived from an organic structure directing agent which is a raw material of the zeolite. The method for producing the zeolite containing, inside the pores, an organic substance, preferably a component derived from an organic structure directing agent is not limited to this method, but for example, in the process of producing the zeolite, a calcination treatment that is usually performed is not performed or partially performed. Specific examples of the characteristics of the zeolite containing, inside the pores, an organic substance, preferably a component derived from an organic structure directing agent include having a weight loss percentage at 800°C of 1% or more based on a weight at 400°C when the temperature is raised to 800°C at a temperature raising rate of 10°C/min in an air atmosphere and held at 800°C for 10 minutes through thermogravimetric analysis (TGA). In the zeolite containing, inside the pores, an organic substance, preferably a component derived from an organic structure directing agent, the value of the weight loss percentage seems to be larger than that of a zeolite that is usually calcined (which hereinafter may be referred to as "calcined zeolite") because the adsorbed water and the organic substance, preferably the organic structure directing agent, present inside the pores of the zeolite are desorbed in a heat treatment in the high temperature region of from 400°C to 800°C.

In the resin composition according to the first aspect of the present invention (which hereinafter may be referred to as "present resin composition I") described later, the cured product exhibits low hygroscopicity by using such a zeolite containing, inside the pores, an organic substance, preferably a component derived from an organic structure directing agent. The mechanism of exhibiting low hygroscopicity with the use of such a zeolite is presumed as follows. Zeolite exhibits adsorbability to water and other substances because zeolite has a porous structure and has an acid site, which is an adsorption site. It is presumed that when an organic substance, preferably a component derived from an organic structure directing agent is present in the porous structure, the zeolite cannot be completely porous, and the adsorbability to water and other substances decreases, thus the hygroscopicity decreases. From the viewpoint described above, the present zeolite I has a weight loss percentage at 800°C (which hereinafter may be simply referred to as "weight loss percentage") of 1% or more based on a weight at 400°C, preferably 2% or more, more preferably 3% or more when the present zeolite I is heated to 800°C at a temperature raising rate of 10°C/min and held at 800°C for 10 minutes in an air atmosphere through thermogravimetric analysis (TGA). The weight loss percentage may be 5% or more, 10% or more, or 20% or more. The upper limit value is not particularly limited as long as the effect of the present invention is exhibited, but it may be, for example, 50% or less.

### (Particle Size Distribution of Zeolite)

The present zeolite I is characterized in that particles having a particle size of 3 µm or more are 40% or less in volume-based particle size distribution. When the zeolite in which particles having a particle size of 3 µm or more are 40% or less in volume-based particle size distribution is formed into a resin composition, the resin composition can be sufficiently filled even with a narrow gap. From such a viewpoint, in the volume-based particle size distribution, particles having a particle size of 3 µm or more are preferably 40% or less, more preferably 30% or less, still more preferably 20% or less, particularly preferably 10% or less, most preferably 5% or less. In the volume-based particle size distribution, the lower limit value of the particles having a particle size of 3 µm or more is not particularly limited, and it may be 0% or more.

The volume-based particle size distribution of the present zeolite I is obtained through measurement by a laser diffraction scattering particle size distribution measurement method. Specifically, the volume-based particle size distribution can be measured by the method described in Examples. Examples of the method for satisfying the above-described particle size distribution include performing a classification treatment after hydrothermal synthesis, and adding seed crystals or alkali metals at any ratio during hydrothermal synthesis. These steps may be used alone or in combination.

### (Particle Size of Zeolite)

When the present zeolite I is added to a resin, the particle size of the present zeolite I is preferably large from the viewpoint of hindering an increase in the viscosity of the zeolite. Specifically, the particle size is preferably 0.1 µm or more, more preferably 0.2 µm or more, still more preferably 0.3 µm or more, particularly 0.4 µm or more, particularly 0.5 µm or more, particularly 0.6 µm or more, particularly preferably 0.7 µm or more, 0.8 µm or more, further particularly preferably 0.9 µm or more, most preferably 1.0 µm or more. On the other hand, the particle size is preferably small from the viewpoint of facilitating a uniform mixture of the zeolite and other components such as a resin, and increasing the smoothness of the surface. Specifically, the particle size is preferably 3.0 µm or less, more preferably 2.95 µm or less, still more preferably 2.9 µm or less, particularly 2.8 µm or less, particularly 2.7 µm or less, particularly 2.5 µm or less, particularly 2.4 µm or less, particularly preferably 2.3 µm or less, particularly preferably 2.2 µm or less, further particularly preferably 2.1 µm or less, most preferably 2.0 µm or less.

The particle size of the present zeolite means a median size obtained by volume-based particle size distribution, and the volume-based particle size distribution is obtained through measurement by a laser diffraction scattering particle size distribution measurement method.

In the present zeolite I, a plurality of zeolite particles may be aggregated to form secondary particles, but the particle size of the zeolite in this case is the particle size of the primary particles.

### (Structure of Zeolite)

Zeolite is a compound containing silicon or aluminum and oxygen and having TO₄ units (T element is an element other than oxygen constituting the framework) as a basic unit. Specific examples of the zeolite include crystalline porous aluminosilicate, crystalline porous aluminophosphate (ALPO), and crystalline porous silicoaluminophosphate (SAPO). The present zeolite I may be of any of the structures described above, but aluminosilicates are preferred.

Zeolite is composed of structural units called composite building units (which hereinafter may be referred to as "CBU") in which several (several to several tens) TO₄ units are connected. Thus, it has regular channels (tubular pores) and cavities.

The crystal structure of CBU or zeolite to be described later can be indicated by a code defining the structure of zeolite defined by the International Zeolite Association (IZA). The structure of zeolite can be specified using the zeolite structure database 2018 version (http://www.iza-structure.org/databases/) based on an X-ray diffraction pattern obtained by an X-ray structural analyzer (for example, a tabletop X-ray diffractometer D2 PHASER available from BRUKER).

### (Framework of Zeolite)

The framework of the present zeolite I preferably has d6r as CBU. The presence of d6r makes it easy to obtain a resin composition having a low coefficient of thermal expansion after curing.

Examples of the zeolite having d6r as CBU include zeolites having AEI, AFT, AFV, AFX, AVL, CHA, EAB, EMT, ERI, FAU, GME, JSR, KFI, LEV, LTL, LTN, MOZ, MSO, MWW, OFF, SAS, SAT, SAV, SBS, SBT, SFW, SSF, SZR, TSC, and -WEN type structures.

Among these, zeolite having a structure of a ring having eight or fewer oxygen atoms is particularly preferable from the viewpoint of hindering the infiltration of water molecules into the pores. Examples of the zeolite having a structure of a ring having eight or fewer oxygen atoms include zeolites having AEI, AFT, AFX, CHA, ERI, KFI, SAT, SAV, SFW, and TSC type structures. Among these, zeolites having AEI, AFX, CHA, and ERI type structures are particularly preferable, and zeolites having a CHA-type structure are most preferable, because the structure is stable even when the shape is controlled. In the present description, the structure having a ring having eight or fewer oxygen atoms means a structure in which the number of oxygen atoms is eight when the number of oxygen atoms is the largest among the pores composed of oxygen and the T element (element other than oxygen, the element constituting the framework) that form the zeolite framework.

One of the above-described zeolites may be used alone or two or more thereof may be used in combination.

### (Average Coefficient of Thermal Expansion of Zeolite)

The average coefficient of thermal expansion of the present zeolite I is preferably low, because the average coefficient of thermal expansion of the liquid composition I described later is easily reduced with a small amount. The small amount of the zeolite is also preferable from the viewpoint of hindering a change in various physical properties of the resin due to the addition of the zeolite. In particular, the average coefficient of thermal expansion is preferably low because an increase in the viscosity of the liquid composition I described later can be suppressed. Specifically, the average coefficient of thermal expansion of the zeolite is usually less than 0 ppm/K, preferably -2 ppm/K or less, more preferably -3 ppm/K or less, still more preferably -4 ppm/K or less, particularly preferably -5 ppm/K or less.

On the other hand, the average coefficient of thermal expansion of the zeolite is preferably high from the viewpoint of reducing the difference in the average coefficient of thermal expansion between the zeolite and the resin and hindering the separation of the zeolite and the resin, in consideration of using the zeolite and the resin as the liquid composition I containing the zeolite and the resin to be described later. Thus, the average coefficient of thermal expansion of zeolite is usually -1000 ppm/K or more, preferably -900 ppm/K or more, more preferably -800 ppm/K or more, still more preferably -700 ppm/K or more, particularly preferably -500 ppm/K or more, most preferably -300 ppm/K or more. In particular, when the zeolite is used for sealing material applications, the average coefficient of thermal expansion is preferably high, and specifically, it is usually -100 ppm/K or more, preferably -50 ppm/K or more, more preferably -40 ppm/K or more, still more preferably -30 ppm/K or more, particularly preferably -25 ppm/K or more, most preferably -20 ppm/K or more.

The average coefficient of thermal expansion of zeolite can be measured by calculating a lattice constant using an X-ray diffractometer "D8 ADVANCE" available from BRUKER and X-ray diffraction analysis software "JADE". Here, to eliminate the influence of moisture desorption, the zeolite is usually measured in a dried state.

The average coefficient of thermal expansion of the zeolite is usually measured in the range of from 50 to 100°C. That is, it is a numerical value representing the displacement of the lattice constant per 1°C from the average lattice constant at 50°C and the average lattice constant at 100°C when the zeolite is heated. Here, the average lattice constant at each temperature is an average value of the lattice constants of the a-axis, the b-axis, and the c-axis. The measurement of the average coefficient of thermal expansion is performed by waiting until the lattice constant is stabilized and then gradually raising the temperature.

In general, resin often has a high coefficient of thermal expansion in a high temperature range. Thus, it is preferable that the average coefficient of thermal expansion of zeolite is low particularly when the temperature is raised to a high temperature range. Specifically, the average coefficient of thermal expansion in the range of from 50 to 350°C (high temperature range) is preferably -5 ppm/K or less, more preferably -5.5 ppm/K or less, still more preferably -6 ppm/K or less. Here, the average coefficient of thermal expansion (high temperature range) of zeolite is a numerical value representing the displacement of the lattice constant per 1°C from the average lattice constant at 50°C and the average lattice constant at 350°C when the zeolite is heated.

### (Shape of Zeolite)

The present zeolite I is preferably spherical. When the shape of the zeolite is spherical, an increase in the viscosity of the resin composition containing the zeolite can be suppressed. Specifically, the primary particles have the following circularity.

The term "primary particle" refers to a unit particle containing no crystal grain boundary therein. The "primary particles" can be determined by observation using a scanning electron microscope (SEM).

### <<Circularity>>

The circularity of the primary particles of the present zeolite I is 0.800 or more, preferably 0.810 or more, more preferably 0.820 or more, still more preferably 0.830 or more, particularly preferably 0.835 or more. The upper limit of the circularity of the primary particles is not particularly limited, and it may be 1 or less. The circularity of a cubic zeolite, which is often used in ordinary zeolites, is 0.785.

In the present description, "circularity" is defined as "4 × π × area/(circumference)²". The area and the circumference can be determined by observation using a scanning electron microscope (SEM). In the present description, the "circularity" is an average value of 100 particles obtained in a scanning electron microscope (SEM).

Examples of the method for setting the circularity of the primary particles of the present zeolite I within the above range include performing classification treatment after hydrothermal synthesis, and adding seed crystals, amino acids, a surfactant, and an organic structure directing agent at any ratio during hydrothermal synthesis.

### (Framework Density of Zeolite)

The framework density of the present zeolite I is not particularly limited as long as the effect of the present invention is not impaired. The framework density of the zeolite is preferably low from the viewpoint of facilitating an occurrence of structural vibration of the zeolite and a decrease in the average coefficient of thermal expansion. Therefore, the framework density of the zeolite I is preferably 17.0 T/1000 Å³ or less, more preferably 16.0 T/1000 Å³ or less.

On the other hand, the framework density of the zeolite I is preferably high from the viewpoint of facilitating an increase in the structural stability of the zeolite. The framework density of the zeolite is preferably 12.0 T/1000 Å³ or more, more preferably 13.0 T/1000 Å³ or more, and still more preferably 14.0 T/1000 Å³ or more. When the framework density is within the above range, the zeolite can be used as a stable filler.

The framework density refers to the number of T atoms present per unit volume of zeolite, and is a value determined depending on the structure of zeolite. In this description, numerical values described in the zeolite structure database 2017 version (http://www.iza-structure.org/databases/) of IZA may be used.

Examples of the zeolite with a framework density higher than 16.0 T/1000 Å³ and 17.0 T/1000 Å³ or less can include zeolites of ERI, LTL, LTN, MOZ, OFF, SAT, SSF, and -WEN type structures.

Examples of the zeolite with a framework density higher than 15.0 T/1000 Å³ and 16.0 T/1000 Å³ or less can include zeolites of AEI, AFT, AFV, AFX, AVL, EAB, GME, LEV, MWW, and SFW type structures.

Examples of the zeolite with a framework density higher than 14.0 T/1000 Å³ and 15.0 T/1000 Å³ or less can include zeolites of CHA, KFI, SAS, and SAV type structures.

Examples of the zeolite with a framework density in the range of 14.0 T/1000 Å³ or less can include zeolites of EMT, FAU, JSR, SBS, SBT and TSC type structures.

### (Composition of Zeolite)

The composition of the present zeolite I is not particularly limited as long as the effect of the present invention is not impaired, but an aluminosilicate containing at least an aluminum atom and a silicon atom in the framework structure is preferable because it is advantageous for use in filler applications. One zeolite may be used alone, or two or more thereof may be used in any combination and at any ratio.

When an element such as gallium, iron, boron, titanium, zirconium, tin, zinc, or phosphorus is used instead of silicon or aluminum, the mole ratio of the oxide of the element used instead may be converted as the mole ratio of alumina or silica. Specifically, when gallium is used instead of aluminum, the mole ratio of gallium oxide may be converted into the mole ratio of alumina.

### (Mole Ratio of Silica/Alumina in Zeolite (SAR))

The mole ratio of silica/alumina in the present zeolite I (which hereinafter may be referred to as "SAR", "mole ratio of Si/Al₂", or "Si/Al₂ ratio") is not particularly limited as long as the effect of the present invention is not impaired. The SAR (Si/Al₂ ratio) of the zeolite is preferably high from the viewpoint of increasing the moisture resistance of the cured product and facilitating the control of the amount of the counter cation. Thus, the SAR (Si/Al₂ ratio) of the zeolite is usually 2 or more, preferably 5 or more, more preferably 10 or more, still more preferably 14 or more, particularly 18 or more, particularly 20 or more, particularly 22 or more, particularly 23 or more, particularly 23.5 or more, particularly preferably 24 or more, further particularly preferably 24.5 or more, most preferably 25 or more.

On the other hand, the SAR (Si/Al₂ ratio) of the zeolite is preferably low from the viewpoint of facilitating low-cost production. Thus, the SAR (Si/Al₂ ratio) of the zeolite is usually 2000 or less, preferably 1000 or less, more preferably 500 or less, still more preferably 100 or less, particularly 50 or less, particularly 47.5 or less, particularly 45 or less, particularly 42.5 or less, particularly 40 or less, particularly 39 or less, particularly 38 or less, particularly preferably 37 or less, further particularly preferably 36 or less, most preferably 35 or less. When the Si/Al₂ ratio is within the range described above, the amount of the counter cation is easily controlled, and the production cost of the zeolite is also low.

The Si/Al₂ ratio of the zeolite can be adjusted by the type and ratio of the silicon-containing compound and the aluminum-containing compound as raw materials, the type and amount of the structure directing agent, the use of seed crystals, synthesis conditions such as temperature and time, and the like.

### (Counter Cation of Zeolite)

The counter cation of the present zeolite I is not particularly limited as long as the effect of the present invention is not impaired. The counter cation of the zeolite is usually a component derived from an organic structure directing agent, a proton, an alkali metal ion, or an alkaline earth metal ion. It is preferably a component derived from an organic structure directing agent, a proton, or an alkali metal ion, more preferably a component derived from an organic structure directing agent, a proton, a Li ion, a Na ion, or a K ion, and still more preferably a component derived from an organic structure directing agent. In the case of an alkali metal ion or an alkaline earth metal ion, the smaller the size, the more easily the zeolite exhibits an average coefficient of thermal expansion of less than 0 ppm/K, which is preferable. The components derived from an organic structure directing agent are preferable because they have flexibility as compared with the alkali metal ions and the alkaline earth metal ions, and thus the zeolite easily exhibits an average coefficient of thermal expansion of less than 0 ppm/K.

That is, the zeolite is preferably a component type derived from an organic structure directing agent (hereinafter, it may be described as "as-made"), a proton type, or an alkali metal type, more preferably as-made, a proton type, a Li type, a Na type, or a K type, still more preferably as-made.

### (Crystallinity of Zeolite)

The crystallinity of the present zeolite I is not particularly limited as long as the effect of the present invention is not impaired. The reason for this is presumed to be that the composite building unit (CBU) is a factor having a greater influence because of the average coefficient of thermal expansion of a cured product than the structure defined by IZA with a code. The crystallinity of zeolite can be determined by comparison with an X-ray diffraction peak of zeolite based on a certain X-ray diffraction peak determined by an X-ray diffractometer (for example, a tabletop X-ray diffractometer D2 PHASER available from BRUKER). Specific examples of the calculation include the crystallinity of the LTA-type zeolite of Scientific Reports 2016 and 6, Article number: 29210.

### (Surface Treatment on Zeolite)

The present zeolite I may be subjected to a surface treatment such as a silylation treatment or a fluorination treatment as long as the effect of the present invention is not impaired. The surface treatment may be a physical treatment or a chemical treatment.

### (Content of Zeolite)

The content of the present zeolite I in the present resin composition I is preferably 40 mass% or more, more preferably 45 mass% or more, still more preferably 50 mass% or more, relative to the total amount of the resin composition, from the viewpoint of reducing the coefficient of thermal expansion of the resin composition. On the other hand, the content of the present zeolite I in the present resin composition I is preferably 95 mass% or less, more preferably 90 mass% or less, still more preferably 85 mass% or less, relative to the total amount of the resin composition, from the viewpoint of suppressing an increase in the viscosity of the resin composition.

### <Inorganic Filler Other Than Zeolite>

The present resin composition I may contain an inorganic filler other than the present zeolite I (hereinafter, the inorganic filler may be referred to as "another inorganic filler I"). Another inorganic filler I is not particularly limited as long as the effect of the present invention is not impaired, and examples thereof include at least one selected from the group consisting of metal, carbon, metal carbide, metal oxide, and metal nitride.

Examples of the metal include silver, copper, aluminum, gold, nickel, iron, and titanium. Examples of the carbon include carbon black, carbon fiber, graphite, fullerene, and diamond. Examples of the metal carbide include silicon carbide, titanium carbide, and tungsten carbide. Examples of the metal oxide include magnesium oxide, aluminum oxide (alumina), silicon oxide such as silica, calcium oxide, zinc oxide, yttrium oxide, zirconium oxide, cerium oxide, ytterbium oxide, and sialon (ceramics including silicon, aluminum, oxygen, and nitrogen). Examples of the metal nitride include boron nitride, aluminum nitride, and silicon nitride.

Among these inorganic fillers, silica is preferable from the viewpoint of reducing the viscosity of the resin composition.

The average particle size of another inorganic filler I is not particularly limited as long as the effect of the present invention is exhibited, but it is preferably in the range of 0.1 µm or more and 5 µm or less. When the average particle size has a value equal to or more than the lower limit value, the viscosity of the resin composition can be reduced, and when the average particle size has a value equal to or less than the upper limit value, the filling property into narrow gaps improves. From the above-described viewpoint, the average particle size of another inorganic filler I is more preferably in the range of 0.2 µm or more and 4 µm or less, still more preferably in the range of 0.5 µm or more and 2 µm or less.

The content of the present zeolite I in all the inorganic fillers is preferably 50 mass% or more, more preferably 60 mass% or more, still more preferably 70 mass% or more, from the viewpoint of sufficiently exhibiting the effect of the present zeolite I, that is, low CTE.

### <Total Inorganic Filler Amount>

The total content of all the inorganic fillers (all inorganic fillers) contained in the present resin composition I is preferably high from the viewpoint of facilitating the fillers to exhibit the effect. On the other hand, when the present resin composition I is in liquid form at normal temperature, it is preferable that the content of all the inorganic fillers is low from the viewpoint of high fluidity and easy filling even in a narrow space. Specifically, the total content of all the inorganic fillers is preferably 40 mass% or more, more preferably 45 mass% or more, still more preferably 50 mass% or more, relative to the total amount of the resin composition. On the other hand, the total content is preferably 95 mass% or less, more preferably 90 mass% or less, still more preferably 85 mass% or less.

### <Dispersant>

The present resin composition I may contain a dispersant to enhance the dispersibility of the inorganic filler such as the present zeolite I. The dispersant contained in the liquid composition I containing a resin and a filler is mainly added to the liquid composition I containing a resin and a filler having a large polarity difference, thereby improving the interface state between the two and improving the compatibility. This makes it possible to exhibit effects such as reduction in viscosity, improvement in dispersibility of fillers, filler aggregation, and prevention of sedimentation.

Examples of the dispersant include an acrylic dispersant and a polymeric dispersant. Here, the "polymeric dispersant" means a dispersant having a weight-average molecular weight of 1000 or more. The dispersant is preferably a polymeric dispersant. The main chain backbone of the polymer dispersant is not particularly limited, but examples thereof include a polyurethane backbone, a polyacrylic backbone, a polyester backbone, a polyamide backbone, a polyimide backbone, and a polyurea backbone. A polyurethane backbone, a polyacrylic backbone, and a polyester backbone are preferable from the viewpoint of storage stability. The structure of the polymeric dispersant is not particularly limited either, and examples thereof include a random structure, a block structure, a comb structure, and a star structure. Similarly, from the viewpoint of storage stability, a block structure or a comb structure is preferable.

The dispersant is preferably a solvent-free type dispersant containing no solvent, in particular, a solvent-free type polymer dispersant. When the dispersant contains no solvent, it is possible to prevent generation of voids due to volatilization of the dispersant when the resin composition is heated and cured.

As the dispersant, a commercially available product can be used. Examples of commercially available products include the following dispersants, and among these, a dispersant having at least any functional group of an amino group and an amine salt may be used.

Examples of commercially available products of the polymeric dispersant include: 101, 102, 103, 106, 108, 109, 110, 111, 112, 116, 130, 140, 142, 145, 161, 162, 163, 164, 166, 167, 168, 170, 171, 174, 108, 182, 183, 184, 185, 2000, 2001, 2008, 2020, 2050, 2070, 2096, 2150, 2152, and 2155 of the wet dispersant DISPERBYK series commercially available from BYK Japan K.K.; 4008, 4009, 4010, 4015, 4020, 4046, 4047, 4050, 4055, 4060, 4080, 4300, 4330, 4340, 4400, 4401, 4402, 4403, 4406, 4800, 5010, 5044, 5054, 5055, 5063, 5064, 5065, 5066, 5070, and 5244 of the EFKA series commercially available from BASF Japan Ltd.; 3000, 5000, 11200, 13240, 13650, 13940, 16000, 17000, 18000, 20000, 21000, 24000SC, 24000GR, 26000, 28000, 31845, 32000, 32500, 32550, 32600, 33000, 34750, 35100, 35200, 36000, 36600, 37500, 38500, 39000, 53095, 54000, 55000, 56000, and 71000 of the Solsperse series commercially available from Lubrizol; 1210, 1220, 1831, 1850, 1860, 2100, 2150, 2200, 7004, KS-260, KS-273N, KS-860, KS-873N, PW-36, DN-900, DA-234, DA-325, DA-375, DA-550, DA-1200, DA-1401, and DA-7301 of the DISPARLON series commercially available from Kusumoto Chemicals, Ltd.; PB-711, PB-821, PB-822, PN-411, and PA-111 of the AJISPER series commercially available from Ajinomoto Corporation; 104A, 104C, 104E, 104H, 104S, 104BC, 104DPM, 104PA, 104PG-50 420, 440, DF110D, DF110L, DF37, DF58, DF75, DF210, CT111, CT121, CT131, CT136, GA, TG, and TGE of SURFYNOL series commercially available from Air Products and Chemicals, Inc.; STG and E1004 of OLFINE series commercially available from Nissin Chemical Industry Co., Ltd.; 70, 2120, and 2190 of SN sparse series commercially available from SAN NOPCO LIMITED; Adekacole and Adekatol series commercially available from ADEKA CORPORATION; and SANNONIC series, Naroacty CL series, EMULMIN series, NEWPOL PE series, IONET M series, IONET D series, and IONET S series, IONET T series, SANSEPARER 100 and the like commercially available from Sanyo Chemical Industries, Ltd.

The content of the dispersant is preferably high from the viewpoint of, for example, easily and uniformly dispersing the inorganic filler in the liquid composition I. On the other hand, the content of the dispersant is preferably low from the viewpoint of hindering the occurrence of an increase in the coefficient of thermal expansion due to phase separation between the inorganic filler and a resin such as an epoxy resin. Thus, the content of the dispersant is preferably 0.1 mass% or more and 30 mass% or less, more preferably 0.1 mass% or more and 25 mass% or less, relative to the total amount of the resin composition, because the liquid composition I is easily filled in a narrow space, and the low coefficient of thermal expansion is easily obtained after curing.

### <Method for Producing Zeolite>

As a method for producing the zeolite, a known method can be applied. For example, when a CHA-type zeolite is produced, the CHA-type zeolite can be produced with reference to a method described in JP 2009-097856 A.

More specifically, an aluminum atom raw material, a silica atom raw material, an organic structure directing agent, and the like are mixed to prepare an aqueous gel. As the mixing order, usually, the aluminum atom raw material is mixed with water, then the silica atom raw material and the organic structure directing agent are mixed therewith. Next, the mixed aqueous gel is subjected to hydrothermal synthesis, a product is separated, and components and the like derived from the raw material adhering thereto are removed by a method such as washing with water and drying, whereby zeolite is obtained.

The particularly preferable zeolite described above can be produced by the following method (hereinafter, it may be described as "present production method I").

The present production method I includes a step of hydrothermally synthesizing a raw material composition containing a silicon atom raw material, an aluminum atom raw material, an organic structure directing agent, and water. In the present production method I, as described above, it is preferable not to perform calcination treatment which is usually performed, or to partially perform calcination as long as the zeolite after the calcination treatment achieves the above-described weight loss percentage of 1% or more. When calcination is partially performed, the calcination conditions described later are preferable.

In the present production method I, calcination treatment can be partially performed as described above, but it is preferable not to perform calcination. That is, the present zeolite I is preferably not calcined (uncalcined). By not performing calcination, the weight loss percentage of 1% or more can be easily achieved, and as a result, a zeolite for obtaining a resin composition having low hygroscopicity, a low coefficient of thermal expansion after curing, low viscosity, and good gap infiltration can be easily produced.

A desired zeolite (which hereinafter may be referred to as "seed crystal zeolite") may be used as necessary.

### <<Silicon Atom Raw Material>>

The silicon atom raw material used in the present invention is not particularly limited, and various known substances can be used. For example, colloidal silica, amorphous silica, sodium silicate, trimethylethoxysilane, tetraethyl orthosilicate, aluminosilicate gel, and zeolite can be used. One of these may be used alone, or two or more thereof may be used in any combination and at any ratio.

### <<Aluminum Atom Raw Material>>

As the aluminum atom raw material, a water-soluble raw material is preferably used. Aluminum hydroxide is preferable in that the content of the alkali metal is low.

### <<Organic Substance>>

As described above, the present zeolite I contains an organic substance inside the pores.

The organic substance is not particularly limited as long as the effect of the present invention is not impaired, and examples thereof include amines, amino acids, fatty acids, surfactants, polymers, and organic structure directing agents. Examples of the amine include trimethylamine, adamantylamine, and morpholine. Examples of the amino acid include lysine, arginine, and ornithine. Examples of the fatty acid include oleic acid and stearic acid. Examples of the surfactant include sodium oleate and sodium stearate. Examples of the polymer include polyethylene glycol and polyethyleneimine. Examples of the organic structure directing agent include those described later. Among these, the organic structure directing agent is preferable because it fills the space in the framework of the zeolite to inhibit the diffusion of water vapor inside the pores and reduce the hygroscopicity. That is, the present zeolite I preferably contains a component derived from an organic structure directing agent as the organic substance.

When the organic substance is used, one type may be used alone, or two or more thereof may be used in any combination and at any ratio.

### <<Organic Structure Directing Agent>>

As the organic structure directing agent, various known substances such as tetramethylammonium hydroxide (TMAOH), tetraethylammonium hydroxide (TEAOH), tetrapropylammonium hydroxide (TPAOH), and N,N,N-trimethyl-1-adamantylammonium hydroxide (TMAdaOH) can be used. Among these, N,N,N-trimethyl-1-adamantylammonium hydroxide (TMAdaOH) is preferable from the viewpoint of easily retaining the organic substance inside the pores of zeolite at a temperature in the range of from room temperature to 200°C and lowering the hygroscopicity of the zeolite. One of these may be used alone, or two or more thereof may be used in any combination and at any ratio.

The amount of the organic structure directing agent to be used is usually 0.01 or more, preferably 0.02 or more, more preferably 0.03 or more, still more preferably 0.04 or more, particularly preferably 0.05 or more in terms of mole ratio relative to silicon (Si) contained in the raw material composition. On the other hand, the amount to be used is usually 1 or less, preferably 0.6 or less, more preferably 0.55 or less, still more preferably 0.5 or less, particularly preferably 0.45 or less, most preferably 0.4 or less. It is considered that a high-purity spherical zeolite with less by-products is likely to grow by using the organic structure directing agent within this range.

### <<Water>>

From the viewpoint of facilitating the formation of crystals, when the seed crystal zeolite described later is used, the amount of water to be used is usually 5 or more, preferably 7 or more, more preferably 9 or more, still more preferably 10 or more in terms of a mole ratio to silicon (Si) contained in the raw material composition other than the seed crystal zeolite. When the amount is within this range, crystals are easily formed, which is preferable. In addition, when the zeolite is hydrothermally synthesized under the condition that the amount of water is increased to dilute the raw material concentration, the zeolite tends to have a large particle size. In addition, from the viewpoint of facilitating the achievement of the cost reduction effect for waste liquid treatment, the mole ratio to silicon (Si) is usually 50 or less, preferably 40 or less, more preferably 30 or less, still more preferably 25 or less.

### <<Alkali Metal Atom Raw Material>>

In the production of the zeolite, an alkali metal atom raw material may be used. The alkali metal atom in the case of using the alkali metal atom raw material is not particularly limited, and a known alkali metal atom used for synthesis of zeolite can be used, but at least one alkali metal selected from the group consisting of lithium, sodium, potassium, rubidium, and cesium is preferable. A plurality of types of alkali metal atoms may be used.

### <<Seed Crystal Zeolite>>

In the present production method I, a zeolite serving as a seed crystal may be used. When seed crystal zeolite is used, one type may be used alone, or two or more thereof may be used in any combination and at any ratio.

### <<Mixing of Raw Materials (Preparation of Raw Material Composition before Reaction)>>

The raw material composition can be usually obtained by mixing a silicon atom raw material, an aluminum atom raw material, an organic structure directing agent, and water, and then adding seed crystal zeolite when it is used.

In the production of zeolite, in addition to the above-described components, components such as an acid component that accelerates the reaction and a metal stabilizer such as polyamine may be added in any step as necessary.

### <<Aging>>

The raw material composition prepared as described above may be hydrothermally synthesized immediately after preparation, but to obtain a zeolite having higher crystallinity, it is preferable to age the raw material composition for a certain period of time under a predetermined temperature condition. In particular, when the reaction is scaled up, it is preferable to age the raw materials while stirring the raw materials for a certain period of time, because the stirring property is improved and the raw materials are easily made into a more uniform state. The temperature in the case of aging is usually 100°C or less, preferably 95°C or less, more preferably 90°C or less. The lower limit thereof is not particularly limited, but the temperature in the case of aging is usually 0°C or more, preferably 10°C or more. The aging temperature may be constant during aging, or may be changed stepwise or continuously. The aging time is not particularly limited, but is usually 2 hours or more, preferably 3 hours or more, more preferably 5 hours or more, and on the other hand, it is usually 30 days or less, preferably 10 days or less, more preferably 4 days or less.

### <<Hydrothermal Synthesis>>

Next, the obtained raw material composition is hydrothermally synthesized.

The hydrothermal synthesis is usually performed by placing the raw material composition prepared as described above or an aqueous gel obtained by aging the raw material composition in a pressure-resistant container, and holding the raw material composition or the aqueous gel at a predetermined temperature under a self-generated pressure or under a gas pressure to such an extent that crystallization is not inhibited, under stirring, while rotating or swinging the container, or in a stationary state.

The reaction temperature in the hydrothermal synthesis is usually 120°C or more, preferably 130°C or more, more preferably 140°C or more, still more preferably 150°C or more to increase the reaction rate. On the other hand, the temperature is usually 230°C or less, preferably 220°C or less, more preferably 200°C or less, still more preferably 190°C or less. The reaction time is not particularly limited, but is usually 2 hours or more, preferably 3 hours or more, more preferably 5 hours or more, and on the other hand, is usually 30 days or less, preferably 10 days or less, more preferably 7 days or less, still more preferably 5 days or less. The reaction temperature may be constant during the reaction, or may be changed stepwise or continuously.

### <<Drying Step>>

After the hydrothermal synthesis, the zeolite is separated from the composition after the hydrothermal synthesis (hydrothermal synthesis reaction liquid). The separation method is not particularly limited, but the separation is usually performed by filtration, decantation, direct drying, or the like after washing with water. Even when the separation is performed by filtration or decantation, the resultant is usually dried.

The drying conditions are not particularly limited, and for example, the drying temperature is preferably 50°C or more and 200°C or less, more preferably 70°C or more and 150°C or less. The atmosphere during drying is not particularly limited, but the drying may be performed in air or under an inert gas atmosphere such as nitrogen or argon.

### <<Calcination>>

The dried zeolite may be subjected to calcination or the like to remove the organic structure directing agent or the like used during the production at any ratio within a range in which the organic substance, preferably a component derived from the organic structure directing agent, is contained inside the pores. By using zeolite containing an organic substance, preferably a component derived from an organic structure directing agent, inside the pores for the present resin composition I, it is possible to provide a resin composition that provides a cured product having low CTE and low hygroscopicity.

When calcination is performed, the calcination temperature is usually preferably from 200 to 1000°C. Calcination at 300°C or more can remove the organic structure directing agent and the like, and on the other hand, when the temperature is 1000°C or less, the physical properties of the zeolite are not impaired. From the above-described viewpoint, the calcination temperature is preferably 300°C or more, more preferably 350°C or more, still more preferably 400°C or more, and preferably 900°C or less, more preferably 800°C or less, still more preferably 700°C or less.

The atmosphere for calcination is not particularly limited, and calcination may be performed in air or under an inert gas atmosphere such as nitrogen or argon.

The calcination method is not particularly limited, and a muffle furnace, a kiln, a fluidized calcination furnace, or the like can be used, but a method in which the gas is circulated and calcined is desirable. The flow rate of the gas is not particularly limited, but usually, the flow amount of the gas per 1 g of powder is preferably in the range of 0.1 ml/min or more and 100 ml/min or less, and more preferably, the calcination is performed under the flow of the gas of 5 ml/min or more and 20 ml/min or less.

### Resin Composition

The present resin composition I contains a zeolite and a resin. The present resin composition I is preferably in liquid form at normal temperature, and when the present resin composition I is in liquid form at normal temperature (hereinafter, the liquid composition may be referred to as "liquid composition I"), the present resin composition I is preferably used as a liquid sealing agent, and is particularly suitable as an underfill material.

Hereinafter, each constituent will be described in detail, but when it is assumed that the resin composition is in liquid form at normal temperature, the resin composition is read as a liquid composition.

In the present description, "liquid form at normal temperature" means having fluidity at a temperature between 10°C and 35°C.

### <Resin>

The resin in the present resin composition I is not particularly limited as long as the effect of the present invention is exhibited, and examples thereof include thermosetting resins and thermoplastic resins. In particular, in consideration of a liquid sealing agent such as an underfill material, it is preferable to contain a thermosetting resin.

### <<Thermosetting Resin>>

The present resin composition I preferably contains a thermosetting resin. The thermosetting resin is not particularly limited, and examples thereof include an epoxy resin, a polyimide resin, a maleimide resin, a polyamide resin, a phenol resin, a vinyl ester resin, an unsaturated polyester resin, and a melamine resin. Among these thermosetting resins, in the present invention, it is preferable to contain at least one selected from the group consisting of an epoxy resin and a polyimide resin, and it is more preferable to contain an epoxy resin.

### (Epoxy Resin)

As the epoxy resin that can be used in the present invention, an epoxy compound having an aromatic ring such as a bisphenol A type backbone, a bisphenol F type backbone, or a biphenyl backbone is preferably used because the coefficient of thermal expansion after curing tends to be low. Specific examples thereof include bisphenol A type epoxy resins, bisphenol F type epoxy resins, bisphenol S type epoxy resins, biphenyl type epoxy resins, naphthalene ring-containing epoxy resins, epoxy resins having a dicyclopentadiene backbone, phenol novolac type resins, cresol novolac type epoxy resins, triphenylmethane type epoxy resins, aminophenol type epoxy resins, aliphatic epoxy resins, and copolymer epoxy resins of aliphatic epoxy resins and aromatic epoxy resins. Among these, bisphenol A type epoxy resins, bisphenol F type epoxy resins, bisphenol S type epoxy resins, biphenyl type epoxy resins, and naphthalene ring-containing epoxy resins are preferable, and bisphenol A type epoxy resins, bisphenol F type epoxy resins, naphthalene ring-containing epoxy resins, aminophenol type epoxy resins, and biphenyl type epoxy resins are more preferably used.

As the present resin composition I, it is preferable to use a polyfunctional epoxy resin from the viewpoint of facilitating an increase in the glass transition temperature after thermal curing. The polyfunctional epoxy resin is preferably a glycidyl ether type polyfunctional epoxy resin such as an epoxy resin produced from various phenols such as a phenol novolac resin, a cresol novolac resin, a bisphenol A novolac resin, a dicyclopentadienephenol resin, a phenol aralkyl resin, a naphthol novolac resin, a biphenyl novolac resin, a terpene phenol resin, and a heavy oil-modified phenol resin, and various phenolic compounds such as a polyhydric phenol resin obtained by a condensation reaction of various phenols with various aldehydes such as hydroxybenzaldehyde, crotonaldehyde, and glyoxal, and epihalohydrin.

From the viewpoint of fluidity, the epoxy resin preferably has a viscosity at 23°C of 5 Pa·s or less, more preferably from 0.1 to 3 Pa·s. The method for measuring the viscosity of the epoxy resin is specified in JISK7233 (1986), and a single cylinder rotational viscometer method is suitable. The viscosity of the epoxy resin used in the present invention at 23°C may be measured using a B-type rotational viscometer ("LVDV-1Pri", available from Brookfield, spindle: S62), which is one of the single cylinder rotational viscometer methods.

From the viewpoint of viscosity control, the epoxy resin has an epoxy equivalent of preferably 50 g/equivalent or more and 500 g/equivalent or less, more preferably 90 g/equivalent or more and 150 g/equivalent or less. The epoxy equivalent is preferably high from the viewpoint of excellent heat resistance. On the other hand, the epoxy equivalent is preferably low from the viewpoint of improving the filling property of the present resin composition I and the bonding property resulting from filling, by reducing the melting point and the viscosity of the epoxy resin.

One epoxy resin may be used alone, or two or more thereof may be mixed and used in any combination and at any ratio, but the epoxy equivalent in the case of mixing is the equivalent of the mixture.

The content of the epoxy resin in the present resin composition I is preferably low from the viewpoint of relatively increasing the content of the inorganic filler such as zeolite and facilitating a decrease in the coefficient of thermal expansion. On the other hand, it is preferable that the content is high from the viewpoint of facilitating the maintenance of excellent physical properties of the epoxy resin. As described above, from the viewpoint of achieving both the maintenance of excellent physical properties of the resin and the heat resistance (difficulty of occurrence of thermal expansion) as a cured resin composition, specifically, the content of the resin is preferably 5 mass% or more, more preferably 10 mass% or more relative to the total amount of the resin composition. On the other hand, the content is preferably 50 mass% or less, more preferably 35 mass% or less, still more preferably 20 mass% or less.

### (Curing Agent)

The present resin composition I preferably further contains a curing agent. The curing agent refers to a substance that contributes to a crosslinking reaction between crosslinking groups of a resin, particularly preferably an epoxy resin.

The curing agent is not particularly limited, and a known resin curing agent can be generally used and a known epoxy resin curing agent can be particularly preferably used. Examples thereof include phenolic curing agents, aliphatic amines, polyether amines, alicyclic amines, amine-based curing agents such as aromatic amines, acid anhydride-based curing agents, amide-based curing agents, tertiary amines, imidazole and derivatives thereof, organic phosphines, phosphonium salts, tetraphenylboron salts, organic acid dihydrazide, halogenated boron amine complexes, polymercaptan-based curing agents, isocyanate-based curing agents, blocked isocyanate-based curing agents, and dicyandiamine compounds. From the viewpoint of imparting fluidity and rapid curability, the curing agent is preferably an acid anhydride-based curing agent.

Specific examples of the phenolic curing agent include bisphenol A, bisphenol F, 4,4'-dihydroxydiphenylmethane, 4,4'-dihydroxydiphenyl ether, 1,4-bis(4-hydroxyphenoxy)benzene, 1,3-bis(4-hydroxyphenoxy)benzene, 4,4'-dihydroxydiphenyl sulfide, 4,4'-dihydroxydiphenyl ketone, 4,4'-dihydroxydiphenyl sulfone, 4,4'-dihydroxybiphenyl, 2,2'-dihydroxybiphenyl, 10-(2,5-dihydroxyphenyl)-10H-9-oxa-10-phosphaphenanthrene-10-oxide, phenol novolac, bisphenol A novolac, o-cresol novolac, m-cresol novolac, p-cresol novolac, xylenol novolac, poly-p-hydroxystyrene, hydroquinone, resorcin, catechol, t-butylcatechol, t-butylhydroquinone, fluoroglycinol, pyrogallol, t-butylpyrogallol, allylated pyrogallol, polyallylated pyrogallol, 1,2,4-benzenetriol, 2,3,4-trihydroxybenzophenone, 1,2-dihydroxynaphthalene, 1,3-dihydroxynaphthalene, 1,4-dihydroxynaphthalene, 1,5-dihydroxynaphthalene, 1,6-dihydroxynaphthalene, 1,7-dihydroxynaphthalene, 1,8-dihydroxynaphthalene, 2,3-dihydroxynaphthalene, 2,4-dihydroxynaphthalene, 2,5-dihydroxynaphthalene, 2,6-dihydroxynaphthalene, 2,7-dihydroxynaphthalene, 2,8-dihydroxynaphthalene, allylated or polyallylated products of these dihydroxynaphthalenes, allylated bisphenol A, allylated bisphenol F, allylated phenol novolac, and allylated pyrogallol.

Specific examples of the amine-based curing agent, as aliphatic amines, include ethylenediamine, 1,3-diaminopropane, 1,4-diaminopropane, hexamethylenediamine, 2,5-dimethylhexamethylenediamine, trimethylhexamethylenediamine, diethylenetriamine, iminobispropylamine, bis(hexamethylene)triamine, triethylenetetramine, tetraethylenepentamine, pentaethylenehexamine, N-hydroxyethylethylenediamine, and

### tetra(hydroxyethyl)ethylenediamine.

Examples of the amine-based curing agent, as polyether amines, include triethylene glycol diamine, tetraethylene glycol diamine, diethylene glycol bis(propylamine), polyoxypropylene diamine, and polyoxypropylene triamine.

Examples of the amine-based curing agent, as alicyclic amines, include isophoronediamine, methacenediamine, N-aminoethylpiperazine, bis(4-amino-3-methyldicyclohexyl)methane, bis(aminomethyl)cyclohexane, 3,9-bis(3-aminopropyl)-2,4,8,10-tetraoxaspiro(5,5)undecane, and norbornenediamine.

Examples of the amine-based curing agent, as aromatic amines, include tetrachloro-p-xylenediamine, m-xylenediamine, p-xylenediamine, m-phenylenediamine, o-phenylenediamine, p-phenylenediamine, 2,4-diaminoanisole, 2,4-toluenediamine, 2,4-diaminodiphenylmethane, 4,4'-diaminodiphenylmethane, 4,4'-diamino-1,2-diphenylethane, 2,4-diaminodiphenylsulfone, 4,4'-diaminodiphenylsulfone, m-aminophenol, m-aminobenzylamine, benzyldimethylamine, 2-dimethylaminomethylphenol, triethanolamine, methylbenzylamine, α-(m-aminophenyl)ethylamine, α-(p-aminophenyl)ethylamine, diaminodiethyldimethyldiphenylmethane, and α,α'-bis(4-aminophenyl)-p-diisopropylbenzene.

Specific examples of the acid anhydride-based curing agent include dodecenyl succinic anhydride, polyadipic anhydride, polyazelaic anhydride, polysebacic anhydride, poly(ethyloctadecanedioic acid)anhydride, poly(phenylhexadecanedioic acid)anhydride, methyltetrahydrophthalic anhydride, methylhexahydrophthalic anhydride, hexahydrophthalic anhydride, methylhymic anhydride, tetrahydrophthalic anhydride, trialkyltetrahydrophthalic anhydride, methylcyclohexene dicarboxylic anhydride, methylcyclohexene tetracarboxylic anhydride, phthalic anhydride, trimellitic anhydride, pyromellitic anhydride, benzophenone tetracarboxylic anhydride, ethylene glycol bistrimellitate dianhydride, hetic anhydride, nadic anhydride, methylnadic anhydride, hydrogenated nadic acid, hydrogenated methylnadic acid, 5-(2,5-dioxotetrahydro-3-furanyl)-3-methyl-3-cyclohexane-1,2-dicarboxylic anhydride, 3,4-dimethyl-6-(2-methyl-1-propenyl)-4-cyclohexene-1,2-dicarboxylic anhydride, 3,4-dicarboxy-1,2,3,4-tetrahydro-1-naphthalene succinic dianhydride, and 1-methyl-dicarboxy-1,2,3,4-tetrahydro-1-naphthalene succinic dianhydride.

Examples of the amide-based curing agent include dicyandiamide and a polyamide resin.

Examples of the tertiary amine include 1,8-diazabicyclo(5,4,0)undecene-7, triethylenediamine, benzyldimethylamine, triethanolamine, dimethylaminoethanol, and tris(dimethylaminomethyl) phenol.

Examples of imidazoles and derivatives thereof include 1-cyanoethyl-2-phenylimidazole, 2-phenylimidazole, 2-ethyl-4(5)-methylimidazole, 2-phenyl-4-methylimidazole, 1-benzyl-2-methylimidazole, 1-benzyl-2-phenylimidazole, 1-cyanoethyl-2-undecylimidazole, 1-cyano-2-phenylimidazole, 1-cyanoethyl-2-undecylimidazole trimellitate, 1-cyanoethyl-2-phenylimidazolium trimellitate, 2,4-diamino-6-[2'-methylimidazolyl-(1')]-ethyl-s-triazine, 2,4-diamino-6-[2'-ethyl-4'-methylimidazolyl-(1')]-ethyl-s-triazine, 2,4-diamino-6-[2'-methylimidazolyl-(1')]-ethyl-s-triazineisocyanuric acid adducts, 2-phenylimidazole isocyanuric acid adducts, 2-phenyl-4,5-dihydroxymethylimidazole, 2-phenyl-4-methyl-5-hydroxymethylimidazole, and adducts of an epoxy resin and the imidazoles or polymer-encapsulated imidazoles.

Examples of the organic phosphines include tributylphosphine, methyldiphenylphosphine, triphenylphosphine, diphenylphosphine, and phenylphosphine. Examples of the phosphonium salt include tetraphenylphosphonium/tetraphenylborate, tetraphenylphosphonium/ethyltriphenylborate, and tetrabutylphosphonium/tetrabutylborate. Examples of the tetraphenylboron salt include 2-ethyl-4-methylimidazole/tetraphenylborate and N-methylmorpholine/tetraphenylborate.

One of these curing agents may be used alone, or two or more thereof may be used in any combination and at any ratio.

When the present resin composition I contains a curing agent, the content of the curing agent is less likely to be affected by residual unreacted epoxy groups and functional groups of the curing agent. Thus, when the curing agent is a phenolic curing agent, an amine-based curing agent, or an acid anhydride-based curing agent, the curing agent is used such that the equivalent ratio of the epoxy groups in the epoxy resin to the functional groups in the curing agent (functional groups in the curing agent/epoxy groups in the epoxy resin) is preferably in the range of from 0.8 to 2.0, more preferably in the range of from 0.8 to 1.5.

When the curing agent is an amide-based curing agent, a tertiary amine, imidazole and a derivative thereof, an organic phosphine, a phosphonium salt, a tetraphenylboron salt, an organic acid dihydrazide, a halogenated boron amine complex, a polymercaptan-based curing agent, an isocyanate-based curing agent, a blocked isocyanate-based curing agent, or the like, it is preferably used in an amount of 0.1 parts by mass or more, more preferably 0.5 parts by mass or more, relative to 100 parts by mass of the epoxy resin. On the other hand, the amount is preferably 20 parts by mass or less, more preferably 15 parts by mass or less.

In the case of the dicyandiamine compound, it is preferable to use 0.1 parts by mass or more, more preferably 0.5 parts by mass or more, relative to 100 parts by mass of the epoxy resin. On the other hand, the amount is preferably 10 parts by mass or less, and more preferably 6 parts by mass or less.

### <Reactive Diluent>

When the present resin composition I is in liquid form, the present resin composition I may contain a reactive diluent. The reactive diluent is not particularly limited as long as it contains at least one monofunctional epoxy compound. The monofunctional epoxy compound is an epoxy compound having one epoxy group, and has been used as a reactive diluent for adjusting the viscosity of an epoxy resin composition from before. The monofunctional epoxy compound is roughly classified into an aliphatic monofunctional epoxy compound and an aromatic monofunctional epoxy compound, and is preferably an aromatic monofunctional epoxy compound from the viewpoint of viscosity.

### Additional Additive

In addition to the above-described agents, the present resin composition I may appropriately contain an additional additive selected from a coupling agent, an ultraviolet inhibitor, an antioxidant, a plasticizer, a flame retardant, a colorant, a fluidity improver, an antifoaming agent, an ion trapping agent, and the like.

When the present resin composition I is in liquid form, the present resin composition I is preferably a solvent-free composition. By making the liquid composition I solvent-free, it is possible to prevent generation of voids and the like due to volatilization of a solvent when the liquid composition I is heated and cured. The solvent is a volatile component, and is a term including water and an organic solvent in the present description. The solvent-free liquid composition I does not substantially contain a solvent, and for example, the content of the solvent is preferably less than 3 mass%, more preferably less than 1 mass%, still more preferably 0 mass% relative to the total amount of the liquid composition I.

### <Method for Producing Present Resin Composition I>

The present resin composition I can be obtained by mixing and kneading a zeolite and a resin, and an inorganic filler other than the zeolite, a curing agent, a dispersant, a reactive diluent, and an additional additive component used as necessary, using a vacuum mixer, a mixing roll, a planetary mixer, or the like, and defoaming the mixture as necessary. The order of blending these components is any order as long as there is no particular problem such as generation of a reaction or a precipitate, and any two or three or more components of the components may be mixed in advance, and then the remaining components may be mixed, or all the components may be mixed at once.

### <Physical Properties of Present Resin Composition I>

### (Average Coefficient of Thermal Expansion (CTE))

The average coefficient of thermal expansion (CTE) of the cured product at 25 to 100°C when the present resin composition I is cured to have a gel fraction of 80% or more is preferably 0 ppm/K or more, more preferably 2 ppm/K or more, still more preferably 4 ppm/K or more, particularly preferably 10 ppm/K or more. On the other hand, the average coefficient of thermal expansion is preferably 100 ppm/K or less, more preferably 50 ppm/K or less, still more preferably 30 ppm/K or less.

Since such a resin composition has a low average coefficient of thermal expansion at a temperature equal to or lower than the glass transition temperature, it is useful as a material requiring various types of heat resistance, and is particularly effective for application to electronic devices.

The average coefficient of thermal expansion may be measured by thermomechanical analysis on a cured product obtained by curing the resin composition to have a gel fraction of 80% or more. Specific measurement conditions are as described in Examples.

### (Viscosity)

The present resin composition I is preferably a composition having fluidity at normal temperature (23°C). The viscosity of the present resin composition I is preferably low from the viewpoint of facilitating the filling of the resin composition even in a narrow space. On the other hand, the viscosity is preferably high from the viewpoint of hindering the occurrence of liquid dripping at the time of filling the resin composition. The viscosity of the present resin composition I at 23°C is preferably 0.1 Pa·s or more, more preferably 1 Pa·s or more, still more preferably 3 Pa·s or more, particularly preferably 5 Pa·s or more. On the other hand, the viscosity is preferably 250 Pa·s or less, more preferably 150 Pa·s or less, still more preferably 50 Pa·s or less, particularly preferably 20 Pa·s or less.

The viscosity at 23°C may be measured using a B-type rotational viscometer, which is one of the single cylinder rotational viscometer methods. As the B-type rotational viscometer, for example, those described in Examples may be used.

### (Water Absorption Percentage)

The present resin composition I preferably has a water absorption percentage of 5% or less when cured to have a gel fraction of 80% or more. When the water absorption percentage is 5% or less, for example, even in the case of being used as a part of an electronic component such as an underfill material, a problem caused by hygroscopicity hardly occurs. From the above-described viewpoint, the water absorption percentage is preferably as low as possible, more preferably 4% or less, still more preferably 3% or less, particularly preferably 2% or less.

The water absorption percentage can be measured by the method described in Examples.

### (Gap Filling Distance)

In the present resin composition I, the gap filling distance for entering a gap of 7 µm when held at 80°C for 10 minutes is preferably 10.0 cm or more, more preferably 10.5 cm or more, still more preferably 11.0 cm or more. When the gap filling distance is equal to or longer than this length, for example, when the present resin composition is used as a part of an electronic component such as an underfill material, the composition can enter a narrow gap in a favorable manner.

The gap filling distance can be measured by the method described in Examples.

### [Application]

The present resin composition I can be used for, for example, a catalyst module, a molecular sieve membrane module, an optical member, a moisture absorbing member, a food product, a building member, a constituent member or a packaging member for an electronic device, and the like, and is particularly preferably used for an electronic device.

The electronic device is a device including two or more electrodes, and is a device that controls a current flowing between the electrodes and a voltage generated by electricity, light, magnetism, a chemical substance, or the like, or a device that generates light, an electric field, or a magnetic field by an applied voltage or current. Specific examples thereof include a resistor, a rectifier (diode), a switching element (transistor, thyristor), an amplifying element (transistor), a memory element, a chemical sensor, or the like, and a device obtained by combining or integrating these elements. Examples also include a photodiode or a phototransistor that generates a photocurrent, an electroluminescent element that emits light when an electric field is applied, a photoelectric conversion element that generates an electromotive force by light, and a light element such as a solar cell. The electronic device is preferably a semiconductor device. The semiconductor device preferably has at least a semiconductor substrate, and examples thereof include a device in which a semiconductor chip is mounted on a substrate, and a device in which a semiconductor chip and a semiconductor substrate are stacked in multiple layers.

### <Liquid Sealing Agent>

When the present resin composition I is in liquid form, it is preferably used as a liquid sealing agent, and in such a case, the liquid composition I is cured to form a sealing material.

The liquid sealing agent may be filled in a gap formed in the constituent member, and then cured to be used as a sealing material for filling the gap. A method for producing the sealing material, which includes a step of filling a gap with the resin composition and then curing the resin composition, is also within the scope of the present invention.

The liquid sealing agent may be used as a sealing material for filling a gap between constituent members, for example, by being applied onto various constituent members, then another constituent member being stacked on the liquid sealing agent, and then being cured as appropriate. In this case, the liquid sealing agent may be appropriately cured and B-staged before another constituent member is stacked.

Among these, the present resin composition I, particularly the liquid composition I in which the present resin composition I is in liquid form, is preferably used for the purpose of filling gaps with the liquid composition I and curing the liquid composition I. That is, it is preferable to produce a sealing material by filling gaps with the present resin composition I and then curing the resin composition I.

The present resin composition I is preferably used as a liquid sealing agent, and particularly preferably used as an underfill material. The underfill material is preferably used in the production of an electric device, particularly a semiconductor device, and is preferably used for filling gaps formed between a substrate and a semiconductor chip, between substrates, between semiconductor chips, or the like, for example. As the substrate, a known substrate can be used, and a substrate made of an organic material such as an epoxy resin substrate or a phenol resin substrate may be used. The semiconductor chip may be formed from a semiconductor substrate such as a silicon substrate.

The present resin composition I has a low coefficient of thermal expansion of a cured product thereof, and when used as an underfill material, a difference from the coefficient of thermal expansion of a semiconductor substrate or the like is reduced, and thus, thermal cycle resistance and the like improve.

For example, in a stack in which a semiconductor chip is mounted on a substrate, the underfill material is preferably used as a sealing material that is filled in a gap between the substrate and the semiconductor chip and then cured by heating to seal between the substrate and the chip. In this case, the semiconductor chip is preferably bonded to the surface of the substrate on which a wiring pattern is formed via a bump by reflow or the like, for example, before being filled with the underfill material.

The underfill material may be used in producing a semiconductor device by a pre-applying method. Specifically, on the surface of the semiconductor chip on which a plurality of bumps are formed, an underfill material is filled between the plurality of bumps to form an underfill layer. Here, the filled underfill material may be B-staged as necessary. Thereafter, the semiconductor chip on which the underfill layer is formed may be placed on a surface of the substrate such that the surface on which the underfill layer is formed faces the substrate. Next, the underfill layer may be cured by heating and pressurization or the like to become a sealing material, and the semiconductor chip may be bonded to the surface of the substrate on which the wiring pattern is formed via the bumps.

In the pre-applying method, an underfill material may be applied onto the surface of the substrate on which the wiring pattern is formed to form an underfill layer. Here, the applied underfill layer may be B-staged as necessary. Thereafter, the semiconductor chip on which bumps are formed may be placed on the substrate on which the underfill layer is formed such that the surface on the side where the bump is formed faces the surface of the substrate on which the underfill layer is formed. Thereafter, the underfill layer may be cured by heating and pressurization or the like to become a sealing material, and the semiconductor chip may be bonded to the surface of the substrate on which the wiring pattern is formed via the bumps.

In the above description, an example has been described in which the underfill material is used as a sealing material for filling a gap between a substrate and a semiconductor chip, but the application of the underfill material is not particularly limited, and the underfill material may be used as a sealing material or the like for filling a gap between semiconductor chips or between substrates. The substrate is not limited to a substrate made of an organic material, but it may be a semiconductor substrate or the like.

### Second Aspect

### Resin Composition

A resin composition according to a second aspect of the present invention (which hereinafter may be referred to as "present resin composition II") contains a zeolite, an inorganic filler other than the zeolite, and a resin. The present resin composition II is preferably in liquid form at normal temperature, and when the present resin composition II is in liquid form at normal temperature (hereinafter, the liquid composition may be referred to as "liquid composition II"), the present resin composition II is preferably used as a liquid sealing agent, and is particularly suitable as an underfill material.

Hereinafter, each constituent will be described in detail, but when it is assumed that the resin composition is in liquid form at normal temperature, the resin composition is read as a liquid composition.

In the present description, "liquid form at normal temperature" means having fluidity at a temperature between 10°C and 35°C.

In the second aspect, an object of the present resin composition II is to provide a resin composition having a low coefficient of thermal expansion after curing, low hygroscopicity, and low viscosity.

The present resin composition II can provide a resin composition having a low coefficient of thermal expansion after curing, low hygroscopicity, and low viscosity.

More specifically, the gist of the present resin composition II is as follows.
[1'] A resin composition including a zeolite; an inorganic filler other than the zeolite; and a resin, in which a weight loss percentage at 800°C based on a weight at 400°C is 1% or more as measured by thermogravimetric analysis (TGA), when the zeolite is heated to 800°C at a temperature raising rate of 10°C/min and held at 800°C for 10 minutes in an air atmosphere.
[2'] The resin composition according to [1'], in which the zeolite has d6r as CBU.
[3'] The resin composition according to [1'] or [2'], in which the zeolite includes a zeolite having a structure of a ring having eight or fewer oxygen atoms.
[4'] The resin composition according to any one of [1'] to [3'], in which the zeolite contains a zeolite having a CHA-type structure.
[5'] The resin composition according to any one of [1'] to [4'], in which the zeolite has a sphericity of 0.7 or more.
[6'] The resin composition according to any one of [1'] to [5'], in which the zeolite has a circularity of 0.800 or more.
[7'] The resin composition according to any one of [1'] to [6'], in which the zeolite is an aluminosilicate.
[8'] The resin composition according to any one of [1'] to [7'], in which the inorganic filler other than zeolite is silica.
[9'] The resin composition according to any one of [1'] to [8'], in which the inorganic filler other than the zeolite has an average particle size of from 0.1 to 5 µm.
[10'] The resin composition according to any one of [1'] to [9'], in which a mass ratio of the zeolite to the inorganic filler other than the zeolite is from 5/65 to 40/30.
[11'] The resin composition according to any one of [1'] to [10'], in which a content of the inorganic filler other than the zeolite is from 1 to 50 mass%.
[12'] The resin composition according to any one of [1'] to [11'], in which the resin includes a thermosetting resin.
[13'] The resin composition according to [12'], in which the thermosetting resin includes an epoxy resin.
[14'] A liquid sealing agent including the resin composition described in any one of [1'] to [13'].
[15'] An underfill material including the resin composition described in any one of [1'] to [13'].
[16'] A method for producing a sealing material, the method including filling a gap with the resin composition described in any one of [1'] to [13'] and then curing the resin composition.
[17'] An electronic device including the sealing material produced by the production method described in [16'].

### <Zeolite>

The zeolite used in the present resin composition II (hereinafter, it may be described as "present zeolite II") is the same as the present zeolite I described above, and is characterized by containing, inside the pores, an organic substance, preferably a component derived from an organic structure directing agent which is a raw material of the zeolite. Specifically, the present zeolite II has a weight loss percentage at 800°C of 1% or more based on a weight at 400°C when the temperature is raised to 800°C at a temperature raising rate of 10°C/min in an air atmosphere and held at 800°C for 10 minutes through thermogravimetric analysis (TGA).

The structure of the zeolite, the framework of the zeolite, the average coefficient of thermal expansion of the zeolite, the framework density of the zeolite, the composition of the zeolite, the mole ratio of silica/alumina (SAR) of the zeolite, the counter cation of the zeolite, the crystallinity of the zeolite, the specific aspect and the preferred aspect of the surface treatment of the zeolite in the present zeolite II are the same as those of the present zeolite I described above, and all of them can be incorporated herein.

### (Particle Size of Zeolite)

The particle size of the present zeolite II is preferably 5.0 µm or less. When the particle size of the zeolite is 5.0 µm or less, the resin composition can be sufficiently filled even in a narrow gap. From the above-described viewpoint, the particle size of the present zeolite II is preferably as small as possible, and the lower limit is not particularly limited. In addition, there is also an advantage that the small particle size of the zeolite facilitates a uniform mixture of the zeolite and other components such as a resin.

Specifically, the particle size of the present zeolite II is more preferably less than 5.0 µm, still more preferably 4.5 µm or less, particularly preferably 4.0 µm or less.

On the other hand, the lower limit value is not particularly limited, but it may be 0.05 µm or more, 0.1 µm or more, 0.3 µm or more, 0.5 µm or more, or 1.0 µm or more, from the viewpoint of facilitating the handling and hindering an increase in the viscosity of the present resin composition II.

The particle size of the present zeolite II is intended to mean the diameter (equivalent circle diameter) of a circle having an area equal to the projected area of the particles and having the maximum diameter in the observation of the particles using a scanning electron microscope (SEM). In the present zeolite II, a plurality of zeolite particles may be aggregated to form secondary particles, but the particle size of the zeolite in this case is the particle size of the primary particles.

When the zeolite is used, usually, the zeolite particles are used not as one but as a group of a plurality of zeolite particles. That is, in one aspect of the present invention, the zeolite group is preferably used as a zeolite group containing at least the present zeolite II particles. The average primary particle size of the zeolite in one aspect including such a plurality of zeolite particles is preferably in the range of 0.05 µm or more and 5.0 µm or less, more preferably 0.1 µm or more and 4.0 µm or less, still more preferably 0.5 µm or more and 3.5 µm or less. The average primary particle size of zeolite is determined by randomly selecting 50 zeolites (powder, particles in liquid composition II), measuring their particle sizes, and calculating the average of the particle sizes.

### (Shape of Zeolite)

The present zeolite II is preferably spherical. When the shape of the zeolite is spherical, an increase in the viscosity of the resin composition containing the zeolite can be suppressed. Specifically, the zeolite preferably has the following sphericity and circularity.

### <<Sphericity>>

The sphericity of the present zeolite II is preferably 0.7 or more, more preferably 0.8 or more. The upper limit of the sphericity is not particularly limited, and it may be 1 or less. The sphericity of a cubic zeolite, which is often used in ordinary zeolites, is 0.58. In the present description, the "sphericity" is an average value of 10 particles obtained in a scanning electron microscope (SEM).

In the present description, the "sphericity" is defined as the "ratio of the minimum diameter to the maximum diameter of the particle". The maximum diameter and the minimum diameter can be determined by observation using a scanning electron microscope (SEM).

### <<Circularity>>

The circularity of the present zeolite II is preferably 0.800 or more, more preferably 0.810 or more, still more preferably 0.820 or more, particularly preferably 0.830 or more, most preferably 0.840 or more. The upper limit of the circularity is not particularly limited, and it may be 1 or less. The circularity of a cubic zeolite, which is often used in ordinary zeolites, is 0.785.

In the present description, "circularity" is defined as "4 × π × area/(circumference)²". The area and the circumference can be determined by observation using a scanning electron microscope (SEM). In the present description, the "circularity" is an average value of 10 particles obtained in a scanning electron microscope (SEM).

### (Content of Zeolite)

The content of the present zeolite II in the present resin composition II is preferably 40 mass% or more and 70 mass% or less, more preferably 45 mass% or more and 65 mass% or less, still more preferably 50 mass% or more and 60 mass% or less, relative to the total amount of the resin composition, from the viewpoint of reducing the coefficient of thermal expansion while suppressing an increase in the viscosity of the resin composition.

### <Inorganic Filler Other Than Zeolite>

The present resin composition II contains an inorganic filler other than the present zeolite II (hereinafter, the inorganic filler may be referred to as "another inorganic filler II"). Specific aspects and preferred aspects of another inorganic filler II are the same as those of another inorganic filler I described above, and all of them can be incorporated. The average particle size of the other inorganic filler II and the content of the present zeolite II in all the inorganic fillers are the same as the average particle size of another inorganic filler I and the content of the present zeolite I in all the inorganic fillers, respectively.

One feature of the present resin composition II is that a zeolite and an inorganic filler other than zeolite are used in combination, and when used in combination, both low CTE and viscosity reduction can be achieved. The mass ratio of the inorganic filler other than zeolite to the zeolite is not particularly limited as long as the effect of the present invention is exhibited, but is preferably in the range of from 5/65 to 40/30. When the content is in this range, the above effect is easily obtained. From the above viewpoint, the mass ratio is more preferably in the range of from 10/60 to 35/35.

When the present resin composition II contains an inorganic filler II other than the present zeolite II, the content of another inorganic filler II in the present resin composition II is preferably in the range of 1 mass% or more and 50 mass% or less, more preferably in the range of 5 mass% or more and 40 mass% or less, still more preferably in the range of 10 mass% or more and 35 mass% or less. When the content has a value equal to or more than the lower limit value, the viscosity of the liquid composition II can be reduced, and when the content has a value equal to or less than the upper limit value, the content proportion of the present zeolite II is sufficiently high, and the CTE can be reduced.

### <Total Inorganic Filler Amount>

The total content of all the inorganic fillers (all inorganic fillers) contained in the present resin composition II is preferably high from the viewpoint of facilitating the fillers to exhibit the effect. On the other hand, when the present resin composition II is in liquid form, it is preferable that the content of all the inorganic fillers is low from the viewpoint of high fluidity and easy filling even in a narrow space. Specifically, the total content of all the inorganic fillers is preferably 30 mass% or more, more preferably 35 mass% or more, still more preferably 40 mass% or more, relative to the total amount of the resin composition. On the other hand, the content is preferably 95 mass% or less, more preferably 90 mass% or less, still more preferably 85 mass% or less.

### <Dispersant>

The present resin composition II may contain a dispersant to enhance the dispersibility of the inorganic filler such as the present zeolite II, and is the same as the dispersant which may be contained in the present resin composition I.

### <Method for Producing Zeolite>

Specific aspects and preferred aspects of the method for producing the present zeolite II are the same as those of the present production method I described above, and all of them can be incorporated. That is, in the method for producing the present zeolite II, calcination treatment can be partially performed as in the above-described present production method I, but it is preferable not to perform calcination treatment, and it is preferable that the present zeolite II is not calcined (uncalcined). By not performing calcination treatment, the weight loss percentage of 1% or more can be easily achieved, and further, a zeolite for obtaining a resin composition having a low coefficient of thermal expansion after curing, low hygroscopicity, and low viscosity can be easily produced.

### <Resin, Curing Agent, Reactive Diluent, and Additional Additive>

Specific aspects and preferable aspects of the resin, the curing agent, the reactive diluent, and the additional additive in the present resin composition II are the same as those in the present resin composition I described above, and all of them can be incorporated.

The content of the epoxy resin in the present resin composition II is preferably low from the viewpoint of facilitating a relative increase in the content of the inorganic filler such as zeolite and a decrease in the coefficient of thermal expansion. On the other hand, it is preferable that the content is high from the viewpoint of facilitating the maintenance of excellent physical properties of the epoxy resin. As described above, from the viewpoint of achieving both the maintenance of excellent physical properties of the resin and the heat resistance (difficulty of occurrence of thermal expansion) as a cured resin composition, specifically, the content of the resin is preferably 5 mass% or more, more preferably 10 mass% or more relative to the total amount of the resin composition. On the other hand, the content is preferably 50 mass% or less, more preferably 25 mass% or less, still more preferably 15 mass% or less.

When the curing agent is an amide-based curing agent, a tertiary amine, imidazole and a derivative thereof, an organic phosphine, a phosphonium salt, a tetraphenylboron salt, an organic acid dihydrazide, a halogenated boron amine complex, a polymercaptan-based curing agent, an isocyanate-based curing agent, a blocked isocyanate-based curing agent, or the like, it is preferably used in an amount of 0.1 parts by mass or more, more preferably 0.5 parts by mass or more, relative to 100 parts by mass of the epoxy resin. On the other hand, the amount is preferably 20 parts by mass or less, more preferably 10 parts by mass or less.

In the case of the dicyandiamine compound, it is preferable to use 0.1 parts by mass or more, more preferably 0.5 parts by mass or more, relative to 100 parts by mass of the epoxy resin. On the other hand, the amount is preferably 10 parts by mass or less, and more preferably 6 parts by mass or less.

When the present resin composition II is in liquid form, the present resin composition II is preferably a solvent-free composition. By making the liquid composition II solvent-free, it is possible to prevent generation of voids and the like due to volatilization of the solvent when the liquid composition II is heated and cured. The solvent is a volatile component, and is a term including water and an organic solvent in the present description. The solvent-free liquid composition II does not substantially contain a solvent, and for example, the content of the solvent is preferably less than 3 mass%, more preferably less than 1 mass%, still more preferably 0 mass% relative to the total amount of the liquid composition II.

### <Method for Producing Present Resin Composition II>

The method for producing the present resin composition II is the same as the method for producing the present resin composition I.

### <Physical Properties of Present Resin Composition II>

### (Average Coefficient of Thermal Expansion (CTE))

The average coefficient of thermal expansion (CTE) of the cured product at 25 to 100°C when the present resin composition II is cured to have a gel fraction of 80% or more is preferably 0 ppm/K or more, more preferably 2 ppm/K or more, still more preferably 4 ppm/K or more, particularly preferably 10 ppm/K or more. On the other hand, the average coefficient of thermal expansion is preferably 100 ppm/K or less, more preferably 50 ppm/K or less, still more preferably 25 ppm/K or less.

Since such a resin composition has a low average coefficient of thermal expansion at a temperature equal to or lower than the glass transition temperature, it is useful as a material requiring various types of heat resistance, and is particularly effective for application to electronic devices.

The average coefficient of thermal expansion may be measured by thermomechanical analysis on a cured product obtained by curing the resin composition to have a gel fraction of 80% or more. Specific measurement conditions are as described in Examples.

### (Viscosity)

The present resin composition II is preferably a composition having fluidity at normal temperature (23°C). The viscosity of the present resin composition II is preferably low from the viewpoint of facilitating the filling of the resin composition even in a narrow space. On the other hand, the viscosity is preferably high from the viewpoint of hindering the occurrence of liquid dripping at the time of filling the resin composition. The viscosity of the present resin composition II at 23°C is preferably 0.1 Pa·s or more, more preferably 1 Pa·s or more, still more preferably 5 Pa·s or more, particularly preferably 10 Pa·s or more. On the other hand, the viscosity is preferably 250 Pa·s or less, more preferably 150 Pa·s or less, still more preferably 60 Pa·s or less.

The viscosity at 23°C may be measured using a B-type rotational viscometer, which is one of the single cylinder rotational viscometer methods. As the B-type rotational viscometer, for example, those described in Examples may be used.

### (Water Absorption Percentage)

The present resin composition II preferably has a water absorption percentage of 15% or less when cured to have a gel fraction of 80% or more. When the water absorption percentage is 15% or less, for example, even in the case of being used as a part of an electronic component such as an underfill material, a problem caused by hygroscopicity hardly occurs. From the above-described viewpoint, the water absorption percentage is preferably as low as possible, more preferably 10% or less, still more preferably 5% or less, particularly preferably 3% or less.

The water absorption percentage can be measured by the method described in Examples.

### [Application]

The use of the present resin composition II is the same as the use of the present resin composition I.

When the present resin composition II is in liquid form, it is preferably used as a liquid sealing agent as with the present resin composition I. In such a case, the liquid composition is cured to form a sealing material. That is, the present resin composition II can be read as the present resin composition I, and the liquid composition II can be read as the liquid composition I.

### Examples

Hereinafter, the present invention will be described in more detail with reference to Examples and Comparative Examples, but the present invention is not limited to the following Examples or Comparative Examples without departing from the gist thereof.

### <First Aspect>

Hereinafter, Examples, Comparative Examples, and the like according to the first aspect will be described.

### (Evaluation of Physical Properties)

The physical properties were evaluated as follows.

### (Gel Fraction)

The gel fraction of the cured product was measured by the following procedure. After a heat treatment at 80°C for 2 hours, the cured product produced under the curing condition at 120°C for 2 hours was cut out within a range of from 0.5 to 0.6 g, and placed on a wire mesh. The cured product was allowed to stand for 24 hours while the wire mesh was immersed in acetone. Thereafter, the wire mesh was taken out from the acetone, and dried in vacuum. The proportion of the weight of the cured product after immersion to the weight before immersion was defined as a gel fraction.

### (Weight Loss Percentage)

The weight loss percentage of the zeolite was measured by the following procedure. Approximately 5 mg of zeolite was placed in a platinum cup and charged to a thermal analyzer (device name; TGA Q5000IR, available from TA Instruments). The temperature was raised from room temperature to 800°C at a temperature raising rate of 10°C/min in an air atmosphere, and held at 800°C for 10 minutes. The weight loss percentage at 800°C based on the weight at 400°C was taken as the weight loss percentage. Specifically, it was determined from "weight loss percentage of zeolite = 100 × {(weight at 400°C) - (weight when held at 800°C for 10 minutes)}/(weight at 400°C)".

### (Circularity of Primary Particles)

The circularity of the primary particles of the zeolite was measured by the following procedure. The particles were observed with a scanning electron microscope (SEM) (device name; JSM-6701F, available from JEOL Ltd.). The area and the circumference were determined for 100 particles that can be regarded as primary particles, and calculated from "circularity = 4 × π × area/(circumference)²". The average value of the circularity values of the obtained 100 particles was calculated and used as the circularity of the primary particles of zeolite.

### (Particle Size Distribution)

The particle size distribution of the zeolite was measured by the following procedure. Zeolite powder was added to pure water to form a slurry of about 0.2 mass%, and the slurry was charged into a laser diffraction scattering particle size distribution measuring apparatus (device name; laser diffraction/scattering particle size distribution measuring apparatus Partica mini LA-350, available from HORIBA, Ltd.) through which pure water flowed, and subjected to ultrasonic treatment for 1 minute, and then a volume-based particle size distribution was obtained. The refractive index of water was 1.33, and the refractive index of the zeolite powder was 1.50. In the obtained volume-based particle size distribution measurement, the proportion of particles having a particle size of 3 µm or more to all the particles detected with the device was calculated, and the particles (%) having a particle size of 3 µm or more obtained in the volume-based particle size distribution measurement were used.

### (Particle Size)

The particle size of the zeolite was measured by the following procedure. Zeolite powder was added to pure water to form a slurry of about 0.2 mass%, and the slurry was charged into a laser diffraction scattering particle size distribution measuring apparatus (device name; laser diffraction/scattering particle size distribution measuring apparatus Partica mini LA-350, available from HORIBA, Ltd.) through which pure water flowed, and subjected to ultrasonic treatment for 1 minute, and then a volume-based particle size distribution was obtained. The refractive index of water was 1.33, and the refractive index of the zeolite powder was 1.50. In the obtained volume-based particle size distribution measurement, the median size was calculated and taken as the particle size of the zeolite.

### (Average Coefficient of Thermal Expansion (CTE) of Zeolite)

The average coefficient of thermal expansion of the zeolite was measured by the following procedure. Zeolite previously dried was charged into an X-ray diffractometer (device name; D8 ADVANCE, available from BRUKER), and X-ray diffraction measurement was performed in the range of from 50 to 100°C. The obtained results were subjected to X-ray diffraction analysis software (software name; JADE, available from Materials Data Corporation) to calculate the lattice constants of the a-axis, the b-axis, and the c-axis at each temperature. The average coefficient of thermal expansion of the zeolite was determined from "average coefficient of thermal expansion of zeolite = {(average lattice constant at 100°C) - (average lattice constant at 50°C)}/{(average lattice constant at 50°C) × (100°C - 50°C)}". Here, the average lattice constant at each temperature is an average value of the lattice constants of the a-axis, the b-axis, and the c-axis.

### (Average Coefficient of Thermal Expansion (CTE) of Cured Product)

The average coefficient of thermal expansion of the cured product when the resin composition was cured to have a gel fraction of 80% or more was measured through thermomechanical analysis using a method in accordance with JIS K7197 (2012). The measurement was performed by a compression method using a thermomechanical analyzer (device name: TMA SS7100, available from SII NanoTechnology Inc.).

Specifically, the cured product when the resin composition was cured to have a gel fraction of 80% or more was cut into a size of φ 6 mm × 10 mm, the temperature was measured from 200°C to 20°C at a temperature lowering rate of 5 °C/min by a compression method using a thermomechanical analyzer, the temperature change of the change amount of the sample length at 25 to 100°C was measured, and the gradient of the tangent was taken as the average coefficient of thermal expansion (CTE).

### (Viscosity)

The viscosity of the resin composition at 23°C was measured using a B-type rotational viscometer. As the B-type rotational viscometer, "LVDV-1Pri" available from Brookfield, spindles: S64 and S63 were used when the viscosity was 0.1 to 100 Pa·s, and "HBDV-E" available from Brookfield, spindle: S-07 was used when the viscosity was more than 100 Pa·s. The value measured at 5 rpm was used as a representative value of the viscosity of each sample.

### (Water Absorption Percentage)

The cured product obtained by curing the resin composition to have a gel fraction of 80% or more was held in a drying furnace at 125°C for 3 hours, and then held in a thermo-hygrostat adjusted to 85°C and a humidity of 85% for 3 hours, and the weight change percentage (%) was evaluated.

### (Gap Filling Distance)

A gap of 7 µm was provided on a glass plate having a width of 10 mm, and a test piece sandwiched between the glass plates was prepared. The test piece was placed on a horizontal hot plate heated to 80°C such that one surface of each glass plate was in contact with the test piece, the resin composition was applied to one end side of each glass plate, and the test piece was allowed to stand for 10 minutes. After 10 minutes, the distance by which the resin composition traveled in the gap was measured to evaluate the gap filling distance.

First, Examples of the zeolite according to the first aspect of the present invention will be described.

### Production Example 1-1

In a container, water, N,N,N-trimethyl-1-adamantylammonium hydroxide (TMAdaOH) available from Seichem Corporation as an organic structure directing agent (SDA), sodium oleate available from FUJIFILM Wako Pure Chemical Corporation as a surfactant, "KYOWAAD 200S" available from Kyowa Chemical Industry Co., Ltd. as aluminum hydroxide, and "SNOWTEX N-40" available from Nissan Chemical Corporation as silica were sequentially added.

The composition and mole ratio of the resulting mixture were SiO₂ : Al₂O₃ : TMAdaOH : H₂O : surfactant = 1.0 : 0.025 : 0.3 : 25 : 0.02. Thereafter, CHA-type zeolite as seed crystals was added in an amount of 5 mass% relative to SiO₂ and mixed well, and then the obtained mixture was placed in a pressure-resistant container and subjected to hydrothermal synthesis for 48 hours in an oven at 150°C. The mixture was suction-filtered, washed, and then dried to obtain a CHA-type zeolite.

The obtained zeolite had particles of a volume-based particle size of 3 µm or more in an amount of 1%. The particle size of the obtained zeolite was 1.21 µm. The circularity of the primary particles was 0.839. When the XRD of the resulting powder was measured, the zeolite was confirmed to be CHA-type zeolite. Further, the weight loss percentage of the obtained zeolite was 22.6% as determined by the above method. The average coefficient of thermal expansion of the zeolite at 50 to 100°C was -6.8 ppm/K.

### Production Example 1-2

A zeolite was produced in the same manner as in Production Example 1-1. The produced zeolite was calcined at 600°C for 6 hours under air circulation to obtain calcined zeolite.

The obtained zeolite had particles of a volume-based particle size of 3 µm or more in an amount of 15%. The particle size of the obtained zeolite was 2.07 µm. The circularity of the primary particles was 0.845. When the XRD of the resulting powder was measured, the zeolite was confirmed to be CHA-type zeolite. Further, the weight loss percentage of the obtained zeolite was 0.40% as determined by the above method. The average coefficient of thermal expansion of the zeolite at 50 to 100°C was -9.4 ppm/K.

### Production Example 1-3

In a container, N,N,N-trimethyl-1-adamantylammonium hydroxide (TMAdaOH) available from Seichem Corporation as an organic structure directing agent (SDA), "aluminum hydroxide" available from FUJIFILM Wako Pure Chemical Corporation as aluminum hydroxide, and "CAB-O-SIL M-5" available from Cabot Corporation as silica were sequentially added.

The composition and mole ratio of the resulting mixture were SiO₂ : Al₂O₃ : TMAdaOH : H₂O = 1.0 : 0.025 : 0.4 : 20. After thoroughly mixing, the obtained mixture was placed in a pressure-resistant container and subjected to hydrothermal synthesis for 48 hours in an oven at 150°C. The mixture was suction-filtered, washed, and then dried to obtain a CHA-type zeolite.

The obtained zeolite had particles of a volume-based particle size of 3 µm or more in an amount of 50%. The particle size of the obtained zeolite was 2.98 µm. The circularity of the primary particles was 0.840. When the XRD of the resulting powder was measured, the zeolite was confirmed to be CHA-type zeolite. Further, the weight loss percentage of the obtained zeolite was 24.2% as determined by the above method. The average coefficient of thermal expansion of the zeolite at 50 to 100°C was -5.0 ppm/K.

Next, Examples of the resin composition according to the first aspect of the present invention will be described.

### <Blended Components>

The components used in the preparation of the resin composition are as follows.

### <Epoxy Resin>

(A-1) p-Aminophenol epoxy resin; available from Mitsubishi Chemical Corporation, product name "jER 630", epoxy equivalent: 97 g/equivalent

### <Curing Agent>

(B-1) Acid anhydride curing agent; acid anhydride (main ingredient: hydrogenated methylnadic anhydride): available from New Japan Chemical Co., Ltd., product name "RIKACID HNA-100" (acid anhydride equivalent: 174 to 184)

(C-1) Imidazole-based curing agent; available from Shikoku Chemicals Corporation, product name "2E4MZ-CN"

### <Filler>

(D-1) Zeolite filler 1-1; The zeolite produced in Production Example 1-1 described above was used.

(E-1) Zeolite Filler 1-2; The zeolite produced in Production Example 1-2 described above was used.

(F-1) Zeolite filler 1-3: The zeolite produced in Production Example 1-3 described above was used.

### <Additive>

(G-1) Additive; wet dispersant available from BYK Japan KK, product name "DISPERBYK-2152" (amino group-containing supramolecular weight polyester, comb shape, solvent-free)

### Example 1-1

The filler, resin, curing agent, and additive shown in Table 1 were blended in blending amounts shown in Table 1. Thereafter, the mixture was mixed at 1500 rpm for 5 minutes using a vacuum mixer ("V-mini 300" available from EME Corporation) to prepare a resin composition (liquid composition). The viscosity of the liquid composition was evaluated by the method described above. The results are shown in Table 1.

Next, the gap filling distance of 5 g of the liquid composition was evaluated by the method described above. The results are shown in Table 1.

Next, this liquid composition was poured into a mold, heated at 80°C for 2 hours, then heated at 120°C for 2 hours to be cured to have a gel fraction of 80% or more, and then demolded to obtain a cured product. The CTE and water absorption percentage of the cured product were evaluated by the evaluation method described above. The results are shown in Table 1.

### Comparative Examples 1-1 to 1-2

Resin compositions (liquid compositions) and cured products were obtained in the same manner as in Example 1-1, except that the zeolite filler in Example 1-1 was changed to those shown in Table 1. The results of evaluation by the same method as in Example 1-1 are shown in Table 1.

### [Table 1]

**Table 1**

| | | | Examples | Comparative Example | |
|---|---|---|---|---|---|
| | | | 1-1 | 1-1 | 1-2 |
| Filler physical properties | Weight loss percentage (%) | | 22.6 | 0.40 | 24.2 |
| | Circularity of primary particles (-) | | 0.839 | 0.845 | 0.840 |
| | Proportion (%) of particles having particle size of 3 µm or more obtained through volume-based particle size distribution measurement | | 1 | 15 | 50 |
| Formulation (mass%) | Filler | Zeolite filler 1 | 58 | | |
| | | Zeolite filler 2 | | 58 | |
| | | Zeolite filler 3 | | | 58 |
| | Resin | Epoxy resin | 17 | 17 | 17 |
| | Curing agent | Acid anhydride curing agent | 22 | 22 | 22 |
| | | Imidazole-based curing agent | 2 | 2 | 2 |
| | Additive | Wet dispersant | 1 | 1 | 1 |
| Resin composition physical properties | CTE (ppm/K) | | 28.0 | 20.6 | 26.3 |
| | Viscosity (Pa·s) | | 12 | 120 or more | 8.8 |
| | Water absorption percentage (%) | | 1 | 7 | 2 |
| | Gap filling distance (mm) | | 12 | 4 | 9 |

From the results of Example 1-1 and Comparative Example 1-1, it was found that by using a zeolite containing a component derived from an organic structure directing agent (Example 1-1) as the filler, the viscosity and the water absorption percentage were decreased, and the gap filling distance was increased, as compared with the case of using a calcined zeolite (Comparative Example 1-1). In the calcined zeolite obtained in Comparative Example 1-1, the proportion of particles having a volume-based primary particle size of 3 µm or more is larger than that of the zeolite containing a component derived from an organic structure directing agent obtained in Example 1-1, and this is presumed to be because the particles were fixed to each other through the calcination treatment. The resin composition obtained in Comparative Example 1-1 has a higher viscosity than the resin composition obtained in Example 1-1, and this is presumed to be because when the zeolite is subjected to the calcination treatment, the number of isolated silanol groups on the particle surface increases, and the isolated silanol groups interact with the resin.

From the results of Example 1-1 and Comparative Example 1-2, it was found that the gap filling distance was increased by using zeolite in which particles having a volume-based primary particle size of 3 µm or more were 40% or less as a filler.

That is, the zeolite according to the first aspect of the present invention can provide a resin composition having low hygroscopicity and a low coefficient of thermal expansion after curing, low viscosity, and high gap infiltration.

### <Second Aspect>

Hereinafter, Examples, Comparative Examples, and the like according to the second aspect will be described.

### (Evaluation of Physical Properties)

The physical properties were evaluated as follows.

### (Gel Fraction)

The gel fraction of the cured product was measured by the following procedure. After a heat treatment at 80°C for 2 hours, the cured product produced under the curing condition at 120°C for 2 hours was cut out within a range of from 0.5 to 0.6 g, and placed on a wire mesh. The cured product was allowed to stand for 24 hours while the wire mesh was immersed in acetone. Thereafter, the wire mesh was taken out from the acetone, and dried in vacuum. The proportion of the weight of the cured product after immersion to the weight before immersion was defined as a gel fraction.

### (Weight Loss Percentage)

The weight loss percentage of the zeolite was measured by the following procedure. Approximately 5 mg of zeolite was placed in a platinum cup and charged to a thermal analyzer (device name; TGA Q5000IR, available from TA Instruments). The temperature was raised from room temperature to 800°C at a temperature raising rate of 10°C/min in an air atmosphere, and held at 800°C for 10 minutes. The weight loss percentage at 800°C based on the weight at 400°C was taken as the weight loss percentage. Specifically, it was determined from "weight loss percentage of zeolite = 100 × {(weight at 400°C) - (weight when held at 800°C for 10 minutes)}/(weight at 400°C)".

### (Average Primary Particle Size)

The average primary particle size of the zeolite was measured by the following procedure. The particles were observed with a scanning electron microscope (SEM) (device name; JSM-6701F, available from JEOL Ltd.). Thus, 50 particles that can be regarded as primary particles were randomly extracted, and for each particle, the diameter (equivalent circle diameter) of a circle having an area equal to the projected area of the particle and having the maximum diameter was determined. The average value of the equivalent circle diameters of the obtained 50 particles was calculated and taken as the average primary particle size of the zeolite.

### (Circularity of Primary Particles)

The circularity of the primary particles of the zeolite was measured by the following procedure. The particles were observed with a scanning electron microscope (SEM) (device name; JSM-6701F, available from JEOL Ltd.). The area and the circumference were determined for 10 particles that can be regarded as primary particles, and calculated from "circularity = 4 × π × area/(circumference)²". The average value of the circularity values of the obtained 10 particles was calculated and used as the circularity of the primary particles of zeolite.

### (Sphericity of Primary Particles)

The sphericity of the primary particles of the zeolite was measured by the following procedure. The particles were observed with a scanning electron microscope (SEM) (device name; JSM-6701F, available from JEOL Ltd.). Thus, for 10 particles that can be regarded as primary particles, the maximum diameter and the minimum diameter of the particles were determined, and the ratio of the minimum diameter to the maximum diameter of the particles was calculated. The average value of the sphericity values of the obtained 10 particles was calculated and used as the sphericity of the primary particles of zeolite.

### (Average Coefficient of Thermal Expansion (CTE) of Zeolite)

The average coefficient of thermal expansion of the zeolite was measured by the following procedure. Zeolite previously dried was charged into an X-ray diffractometer (device name; D8 ADVANCE, available from BRUKER), and X-ray diffraction measurement was performed in the range of from 50 to 100°C. The obtained results were subjected to X-ray diffraction analysis software (software name; JADE, available from Materials Data Corporation) to calculate the lattice constants of the a-axis, the b-axis, and the c-axis at each temperature. The average coefficient of thermal expansion of the zeolite was determined from "average coefficient of thermal expansion of zeolite = {(average lattice constant at 100°C) - (average lattice constant at 50°C)}/{(average lattice constant at 50°C) × (100°C - 50°C)}". Here, the average lattice constant at each temperature is an average value of the lattice constants of the a-axis, the b-axis, and the c-axis.

### (Average Coefficient of Thermal Expansion (CTE) of Cured Product)

The average coefficient of thermal expansion of the cured product when the resin composition was cured to have a gel fraction of 80% or more was measured through thermomechanical analysis using a method in accordance with JIS K7197 (2012). The measurement was performed by a compression method using a thermomechanical analyzer (device name: TMA SS7100, available from SII NanoTechnology Inc.).

Specifically, the cured product when the resin composition was cured to have a gel fraction of 80% or more was cut into a size of φ 6 mm × 10 mm, the temperature was measured from 200°C to 20°C at a temperature lowering rate of 5 °C/min by a compression method using a thermomechanical analyzer, the temperature change of the change amount of the sample length at 25 to 100°C was measured, and the gradient of the tangent was taken as the average coefficient of thermal expansion (CTE).

### (Viscosity)

The viscosity of the resin composition at 23°C was measured using a B-type rotational viscometer. As the B-type rotational viscometer, "LVDV-1Pri" available from Brookfield, spindles: S64 and S63 were used when the viscosity was 0.1 to 100 Pa·s, and "HBDV-E" available from Brookfield, spindle: S-07 was used when the viscosity was more than 100 Pa·s. The value measured at 5 rpm was used as a representative value of the viscosity of each sample.

### (Water Absorption Percentage)

The cured product obtained by curing the resin composition to have a gel fraction of 80% or more was held in a drying furnace at 125°C for 3 hours, and then held in a thermo-hygrostat adjusted to 85°C and a humidity of 85% for 3 hours, and the weight change percentage (%) was evaluated.

First, Examples of the zeolite according to the second aspect of the present invention will be described.

### Production Example 2-1 (Production of Uncalcined Zeolite)

In a container, N,N,N-trimethyl-1-adamantylammonium hydroxide (TMAdaOH) available from Seichem Corporation as a structure directing agent (SDA), "KYOWAAD 200S" available from Kyowa Chemical Industry Co., Ltd. as aluminum hydroxide, and "AEROSIL200" available from Nippon Aerosil Co., Ltd. as silica were sequentially added.

The composition and mole ratio of the resulting mixture were SiO₂ : Al₂O₃ : TMAdaOH : H₂O = 1.0 : 0.025 : 0.4 : 20. After thoroughly mixing, the obtained mixture was placed in a pressure-resistant container and subjected to hydrothermal synthesis for 48 hours in an oven at 150°C. The mixture was suction-filtered, washed, and then dried to obtain a CHA-type zeolite.

The obtained uncalcined zeolite was a zeolite in which the particle size of each particle was within the range of 1.0 µm or more and 10 µm or less, and the average primary particle size thereof was 3.1 µm. The uncalcined zeolite at 50 to 100°C had an average coefficient of thermal expansion of -5.0 ppm/K, a sphericity of 0.84, and a circularity of 0.840.

### Production Example 2-2 (Production of Calcined Zeolite)

The uncalcined zeolite produced in Production Example 2-1 was calcined at 600°C for 6 hours under air circulation to obtain calcined zeolite. The obtained calcined zeolite was a zeolite in which the particle size of each particle was within the range of 1.0 µm or more and 10 µm or less, and the average primary particle size thereof was 3.1 µm. The calcined zeolite at 50 to 100°C had an average coefficient of thermal expansion of -9.0 ppm/K, a sphericity of 0.85, and a circularity of 0.845. Other physical properties were the same as those of the uncalcined zeolite.

Next, Examples of the resin composition according to the second aspect of the present invention will be described.

### <Blended Components>

The components used in the preparation of the resin composition are as follows.

### <Epoxy Resin>

(A-2) p-Aminophenol epoxy resin; available from Mitsubishi Chemical Corporation, product name "jER 630", epoxy equivalent: 97 g/equivalent

### <Curing Agent>

(B-2) Acid anhydride curing agent; acid anhydride (main ingredient: hydrogenated methylnadic anhydride): available from New Japan Chemical Co., Ltd., product name "RIKACID HNA-100" (acid anhydride equivalent: 174 to 184)

### <Filler>

(C-2) Zeolite filler 2-1; Uncalcined zeolite, the zeolite produced in Production Example 2-1 described above was used. The weight loss percentage measured using a thermal analyzer (device name; TGA Q5000IR, available from TA Instruments, measurement conditions: in Air) was 22%.

(D-2) Zeolite filler 2-2; Calcined zeolite, the zeolite produced in Production Example 2-2 described above was used. The weight loss percentage measured using a thermal analyzer (device name; TGA Q5000IR, available from TA Instruments, measurement conditions: in Air) was 0.3%.

(E-2) Silica filler; available from Admatechs Co., Ltd., product name "SC4050-SX" (average particle size 1 µm)

### <Additive>

(F-2) Additive; wet dispersant available from BYK Japan KK, product name "DISPERBYK-2152" (amino group-containing supramolecular weight polyester, comb shape, solvent-free)

### Example 2-1

The filler, resin, curing agent, and additive shown in Table 2 were blended in blending amounts shown in Table 2. Thereafter, the mixture was mixed at 1500 rpm for 5 minutes using a vacuum mixer ("V-mini 300" available from EME Corporation) to prepare a resin composition (liquid composition). The viscosity of the liquid composition was evaluated by the method described above. The results are shown in Table 2.

Next, this liquid composition was poured into a mold, heated at 80°C for 2 hours, then heated at 120°C for 2 hours to be cured to have a gel fraction of 80% or more, and then demolded to obtain a cured product. The CTE and water absorption percentage of the cured product were evaluated by the evaluation method described above. The results are shown in Table 2.

### Example 2-2 and Comparative Examples 2-1 to 2-5

Resin compositions (liquid compositions) and cured products were obtained in the same manner as in Example 2-1 except that the components and the blending amounts in Example 2-1 were changed from those shown in Table 2. The results of evaluation by the same method as in Example 2-1 are shown in Table 2.

### [Table 2]

**Table 2**

| | | | Examples | | Comparative Example | | | | |
|---|---|---|---|---|---|---|---|---|---|
| | | | 2-1 | 2-2 | 2-1 | 2-2 | 2-3 | 2-4 | 2-5 |
| Formulation (mass%) | Filler | Zeolite filler 2-2 | 0 | 0 | 60 | 0 | 0 | 60 | 50 |
| | | Zeolite filler 2-1 | 50 | 55 | 0 | 0 | 0 | 0 | 0 |
| | | Silica (1 µm) | 20 | 15 | 0 | 60 | 0 | 10 | 25 |
| | | Total filler amount | 70 | 70 | 60 | 60 | 0 | 70 | 75 |
| | Resin | Epoxy resin | 13 | 13 | 17 | 17 | 42 | 13 | 10 |
| | Curing agent | Acid anhydride curing agent | 16 | 16 | 22 | 22 | 57 | 16 | 14 |
| | Additive | Wet dispersant | 1 | 1 | 1 | 1 | 1 | 1 | 1 |
| Physical properties | CTE (ppm/K) | | 18.6 | 18.6 | 20 | 30 | 64 | 19 | 17.5 |
| | Viscosity (Pa·s) | | 22 | 58 | 33 | 8 | 0.15 | 260 | 350 |
| | Water absorption percentage (%) | | 2.3 | 2.3 | 16 | 1.2 | 2.2 | 12 | 11.2 |

From the results of Examples 2-1 and 2-2 and Comparative Examples 2-4 and 2-5, it was found that when uncalcined zeolite was used as zeolite, the CTE was equivalent to that when calcined zeolite was used, but the viscosity was reduced and the water absorption percentage was reduced.

The resin composition according to the second aspect of the present invention can provide a resin composition having a low coefficient of thermal expansion after curing, low hygroscopicity, and low viscosity. Such a resin composition is suitable for a liquid sealing agent, and is particularly useful as an underfill material.

### Industrial Applicability

The present invention can provide a zeolite for producing a resin composition having low hygroscopicity, a low coefficient of thermal expansion after curing, low viscosity, and high gap infiltration. Such a resin composition is suitable for a liquid sealing agent, and is particularly useful as an underfill material.

## Claims

1. A zeolite wherein a weight loss percentage at 800°C based on a weight at 400°C is 1% or more as measured by thermogravimetric analysis (TGA), when the zeolite is heated to 800°C at a temperature raising rate of 10°C/min and held at 800°C for 10 minutes in an air atmosphere; a circularity of primary particles is 0.800 or more; and 40% or less of particles have a particle size of 3 µm or more as measured by volume-based particle size distribution.

2. The zeolite according to claim 1, having d6r as CBU.

3. The zeolite according to claim 1, having a structure of a ring having eight or fewer oxygen atoms.

4. The zeolite according to claim 1, having a CHA-type structure.

5. A resin composition comprising the zeolite described in any one of claims 1 to 4 and a resin.

6. The resin composition according to claim 5, wherein the resin includes at least one selected from the group consisting of an epoxy resin and a polyimide resin.

7. The resin composition according to claim 5, wherein the resin includes an epoxy resin.

8. A liquid sealing agent comprising the resin composition described in claim 5.

9. An underfill material comprising the resin composition described in claim 5.

10. A method for producing a sealing material, the method comprising filling a gap with the resin composition described in claim 5 and then curing the resin composition.

11. An electronic device comprising the sealing material produced by the production method described in claim 10.
